(19) **Europäisches Patentamt / European Patent Office / Office européen des brevets**

(11) **EP 4 765 695 A1**

(12) **EUROPEAN PATENT APPLICATION**
published in accordance with Art. 153(4) EPC

(43) Date of publication:
**24.06.2026 Bulletin 2026/26**

(51) International Patent Classification (IPC):
**H04L 1/00** (2006.01)

(21) Application number: **24864125.0**

(52) Cooperative Patent Classification (CPC):
**H03M 13/15; H04L 1/00**

(22) Date of filing: **03.06.2024**

(86) International application number:
**PCT/CN2024/097060**

(87) International publication number:
**WO 2025/055400 (20.03.2025 Gazette 2025/12)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **11.09.2023 CN 202311177437**

(71) Applicant: **HUAWEI TECHNOLOGIES CO., LTD.
Shenzhen 518129 (CN)**

(72) Inventors:
• **QIU, Xianwen**
  **Shenzhen, Guangdong 518129 (CN)**
• **LI, Liang**
  **Shenzhen, Guangdong 518129 (CN)**
• **KOU, Hanjun**
  **Shenzhen, Guangdong 518129 (CN)**
• **LIU, Yongzhi**
  **Shenzhen, Guangdong 518129 (CN)**
• **LU, Yuchun**
  **Shenzhen, Guangdong 518129 (CN)**
• **HU, Jun**
  **Shenzhen, Guangdong 518129 (CN)**

(74) Representative: **Goddar, Heinz J.
Boehmert & Boehmert
Anwaltspartnerschaft mbB
Pettenkoferstrasse 22
80336 München (DE)**

(54) **CODER, CODING METHOD AND CHIP**

(57) This application discloses an encoder, an encoding method, and a chip, relating to the field of encoding technologies. A feedback circuit in the encoder is designed to avoid timing convergence issues when the encoder operates in large-bandwidth and high-parallelism input scenarios. The encoder includes: a feedforward module, configured to receive to-be-encoded data with a parallelism of n symbols per cycle, and perform calculation in a finite field based on a symbol of the to-be-encoded data received in a current cycle, to obtain a single-cycle polynomial corresponding to the current cycle; and a feedback module, configured to receive the single-cycle polynomial corresponding to the current cycle output by the feedforward module, and perform calculation in the finite field based on the single-cycle polynomial corresponding to the current cycle and a first polynomial indicating a symbol received in a historical cycle, to obtain a second polynomial, where the second polynomial is used to determine a target polynomial indicating the to-be-encoded data, and the target polynomial is used to generate a check sequence of the to-be-encoded data, to obtain a codeword obtained by encoding the to-be-encoded data based on a forward error correction encoding scheme.

FIG. 10

## Description

This application claims priority to Chinese Patent Application No. 202311177437.8, filed with the China National Intellectual Property Administration on September 11, 2023 and entitled "ENCODER, ENCODING METHOD, AND CHIP", which is incorporated herein by reference in its entirety.

## TECHNICAL FIELD

This application relates to the field of encoding technologies, and in particular, to an encoder, an encoding method, and a chip.

## BACKGROUND

In Ethernet-based data communication scenarios, a data transmitter may use a forward error correction (forward error correction, FEC) technology to encode to-be-transmitted data, so as to ensure reliability of data transmission. FEC is an error control technology that enables selfcorrection and recovery of data when errors occurs during data transmission.

With development of information technologies such as cloud computing, big data, artificial intelligence, and the Internet of things, global data scales are surging. To improve data transmission efficiency, when FEC encoding is performed on to-be-transmitted data, encoders are designed to receive symbols of to-be-encoded data in parallel, enabling FEC encoding on the to-be-encoded data.

However, when parallelism of the symbols of the to-be-encoded data input to the encoder is high, a feedback loop in the current encoder may encounter technical risks relating to timing convergence failure.

## SUMMARY

This application provides an encoder, an encoding method, and a chip. A feedback circuit in the encoder is designed to avoid timing convergence issues when the encoder operates in large-bandwidth and high-parallelism input scenarios.

To achieve the foregoing objective, this application provides the following technical solutions.

According to a first aspect, this application provides an encoder, including: a feedforward module, configured to receive to-be-encoded data with a parallelism of n (n is a positive integer) symbols per cycle, and perform calculation in a finite field based on a symbol of the to-be-encoded data received in a current cycle, to obtain a single-cycle polynomial corresponding to the current cycle, where the single-cycle polynomial indicates a symbol received by the feedforward module in one cycle; and a feedback module, configured to receive the single-cycle polynomial corresponding to the current cycle output by the feedforward module, and perform calculation in the finite field based on the single-cycle polynomial corresponding to the current cycle and a first polynomial indicating a symbol received in a historical cycle, to obtain a second polynomial. The second polynomial indicates symbols received from an initial cycle to the current cycle, and the second polynomial is used to determine a target polynomial indicating the to-be-encoded data. The target polynomial is used to generate a check sequence of the to-be-encoded data, the check sequence of the to-be-encoded data is used to check and correct the to-be-encoded data, and a codeword obtained by encoding the to-be-encoded data based on a forward error correction encoding scheme includes the to-be-encoded data and the check sequence of the to-be-encoded data. In addition, the initial cycle is a first cycle for the feedforward module to receive the to-be-encoded data, and the historical cycle is a cycle that is located before the current cycle in a process in which the feedforward module receives the to-be-encoded data.

When the encoder provided in this application performs encoding, the feedforward module and the feedback module in the encoder perform calculation, to obtain the target polynomial indicating the to-be-encoded data. In addition, when the encoder performs calculation by using the feedforward module and the feedback module to obtain the target polynomial indicating the to-be-encoded data, a feedforward circuit performs calculation to obtain a corresponding single-cycle polynomial based on the symbol received in each cycle, and the feedback module performs at least one iteration calculation on the single-cycle polynomial output by the feedforward module, to obtain, through calculation, the target polynomial indicating the to-be-encoded data. It can be learned that the feedback module is irrelevant to a number of symbols (that is, parallelism) of the to-be-encoded data that are input to the feedforward module in each cycle. It may be understood as that the feedback module is decoupled from parallelism of the to-be-encoded data input to the feedforward module. In this way, in a large bandwidth scenario, even if the to-be-encoded data is input to the encoder at high parallelism, a computational amount of the feedback module does not increase with the high parallelism, to avoid a technical problem in which a timing closure is not achieved in the feedback module.

In a possible design, the to-be-encoded data includes K symbols, and K is a positive integer. When a length of the codeword obtained by encoding the to-be-encoded data based on the forward error correction encoding scheme is N, and N is an integer greater than K, the encoder includes N-K polynomial evaluation modules, and each polynomial evaluation module includes the feedforward module and the feedback module. In addition, the N-K polynomial evaluation modules are configured to perform calculation in the finite field by using the feedforward module and the feedback module in each polynomial evaluation module, to obtain N-K target polynomials indicating the to-be-encoded data.

In another possible design, when the length of the codeword obtained by encoding the to-be-encoded data based on the forward error correction encoding scheme is N+$\Delta$N, the encoder includes N+$\Delta$N-K polynomial evaluation modules, and each polynomial evaluation module includes the feedforward module and the feedback module. In addition, the N+$\Delta$N-K polynomial evaluation modules are configured to perform calculation in the finite field by using the feedforward module and the feedback module in each polynomial evaluation module, to obtain N+$\Delta$N-K target polynomials indicating the to-be-encoded data. The N+$\Delta$N-K polynomial evaluation modules include the N-K polynomial evaluation modules.

For an RS (N, K) code pattern with a codeword length of N and a payload length of K, an error correction capability is (N-K)/2. For an RS (N+$\Delta$N, K) code pattern with a codeword length of N+$\Delta$N and a payload length of K, an error correction capability is (N+$\Delta$N-K)/2. Therefore, based on the foregoing two possible designs, the encoder provided in this application can implement that, in a process of encoding RS code patterns with different error correction capabilities, a polynomial evaluation module in an encoder for an RS code pattern with a high error correction capability can reuse a polynomial evaluation module in an encoder for an RS code pattern with a low error correction capability. In other words, based on the design of the encoder provided in this application, the encoder for the RS code pattern with a high error correction capability and the encoder for the RS code pattern with a low error correction capability can share a common polynomial evaluation module (that is, reused by the two encoders), to greatly reduce a circuit area and power consumption during actual module implementation. When the length of the codeword obtained through encoding is (N+$\Delta$N), an error correction capability is (N+$\Delta$N-K). When the length of the codeword obtained through encoding is N, an error correction capability is N-K.

In another possible design, the encoder further includes: a constant coefficient multiply-add module, configured to perform calculation based on a constant coefficient matrix and the target polynomial, to obtain the check sequence of the to-be-encoded data; and a combination module, configured to combine the to-be-encoded data and the check sequence of the to-be-encoded data, to obtain the codeword obtained by encoding the to-be-encoded data based on the forward error correction encoding scheme.

In another possible design, when the length of the codeword obtained by encoding the to-be-encoded data based on the forward error correction encoding scheme is N, the constant coefficient matrix is an (N-K)$\times$(N-K) first constant coefficient matrix; and when the length of the codeword obtained by encoding the to-be-encoded data based on the forward error correction encoding scheme is N+$\Delta$N, the constant coefficient matrix is a (N+$\Delta$N-K)$\times$(N+$\Delta$N-K) second constant coefficient matrix. The second constant coefficient matrix includes the first constant coefficient matrix.

Based on the foregoing possible design manner, in this application, a preset constant coefficient matrix (the second constant coefficient matrix) in an encoder with a high error correction capability includes a preset constant coefficient matrix (the first constant coefficient matrix) in an encoder with a low error correction capability. In this way, the encoder with a high error correction capability and the encoder with a low error correction capability provided in this application can share a module constructed based on a same coefficient matrix. Therefore, the encoder provided in embodiments of this application can encode forward error correction code patterns with different error correction capabilities, and a circuit area and power consumption of the encoder can be reduced.

In another possible design, the encoder supports encoding of at least one forward error correction code pattern, and each of the at least one forward error correction code pattern has a different error correction capability.

Based on the possible design, the encoder provided in embodiments of this application is a hybrid encoder, for forward error correction encoding, that can support code patterns with a plurality of error correction capabilities.

In another possible design, when a value of n is greater than a threshold, the feedforward module includes a register. The register is configured to control the feedforward module to complete calculation of a single-cycle polynomial in at least two clock cycles.

Based on the possible design, it can be ensured that the feedforward module in the encoder provided in this application completes calculation of a single-cycle polynomial in at least two clock cycles. In other words, in a large bandwidth scenario, even if the to-be-encoded data is input to the encoder at the high parallelism, the encoder provided in this application can complete forward error correction encoding.

In another possible design, when the length of the codeword obtained by encoding the to-be-encoded data based on the error correction encoding scheme is N, and a root of a primitive polynomial in the finite field is $\alpha$, the first constant coefficient matrix is pre-obtained through calculation according to the following formula:

$$\left[\begin{array}{cccc} (\alpha^0)^{-1} & (\alpha^0)^{-2} & \cdots & (\alpha^0)^{K-N} \\ (\alpha^1)^{-1} & (\alpha^1)^{-2} & \cdots & (\alpha^1)^{K-N} \\ \vdots & \vdots & \ddots & \vdots \\ (\alpha^{N-K-1})^{-1} & (\alpha^{N-K-1})^{-2} & \cdots & (\alpha^{N-K-1})^{K-N} \end{array}\right]^{-1}$$

In another possible design, the feedback module is specifically configured to: when the first polynomial is $A_1$ and the polynomial indicating the symbol received in the current cycle is $A_{2a}$, perform calculation according to the following formula: $A_2 = A_1 \times (\alpha^i)^n + A_{2a}$, to obtain the second polynomial $A_2$, where $\alpha^i$ is a root of a generator polynomial in the finite field, and i is an integer in [0, N-K-1].

Based on the possible design, it can be learned that the feedback module in the encoder provided in this application is irrelevant to the parallelism at which the to-be-encoded data is input, that is, the feedback module is decoupled from the parallelism. Therefore, a length of the feedback module is fixed, and does not increase with the parallelism at which the to-be-encoded data is input. Therefore, in a scenario of large bandwidth and an input at high parallelism, a problem in which a timing closure is not achieved does not occur in the feedback module in the encoder provided in this application.

According to a second aspect, this application provides an encoding method. The method is applied to an encoder, and the encoder includes a feedforward module and a feedback module. The method includes: The feedforward module receives to-be-encoded data with a parallelism of n (n is a positive integer) symbols per cycle, and performs calculation in a finite field based on a symbol of the to-be-encoded data received in a current cycle, to obtain a single-cycle polynomial corresponding to the current cycle. The single-cycle polynomial indicates a symbol received by the feedforward module in one cycle. The feedback module receives the single-cycle polynomial corresponding to the current cycle output by the feedforward module, and performs calculation in the finite field based on the single-cycle polynomial corresponding to the current cycle and a first polynomial indicating a symbol received in a historical cycle, to obtain a second polynomial. The second polynomial indicates symbols received from an initial cycle to the current cycle, and the second polynomial is used to determine a target polynomial indicating the to-be-encoded data. The target polynomial is used to generate a check sequence of the to-be-encoded data, the check sequence of the to-be-encoded data is used to check and correct the to-be-encoded data, and a codeword obtained by encoding the to-be-encoded data based on a forward error correction encoding scheme includes the to-be-encoded data and the check sequence of the to-be-encoded data. In addition, the initial cycle is a first cycle for the feedforward module to receive the to-be-encoded data, and the historical cycle is a cycle that is located before the current cycle in a process in which the feedforward module receives the to-be-encoded data.

In another possible design, the to-be-encoded data includes K symbols, and K is a positive integer. When a length of the codeword obtained by encoding the to-be-encoded data based on the forward error correction encoding scheme is N, and N is an integer greater than K, the encoder includes N-K polynomial evaluation modules, and each polynomial evaluation module includes the feedforward module and the feedback module. In addition, the N-K polynomial evaluation modules are configured to perform calculation in the finite field by using the feedforward module and the feedback module in each polynomial evaluation module, to obtain N-K target polynomials indicating the to-be-encoded data.

In another possible design, when the length of the codeword obtained by encoding the to-be-encoded data based on the forward error correction encoding scheme is N+ΔN, the encoder includes N+ΔN-K polynomial evaluation modules, and each polynomial evaluation module includes the feedforward module and the feedback module. In addition, the N+ΔN-K polynomial evaluation modules are configured to perform calculation in the finite field by using the feedforward module and the feedback module in each polynomial evaluation module, to obtain N+ΔN-K target polynomials indicating the to-be-encoded data. The N+ΔN-K polynomial evaluation modules include the N-K polynomial evaluation modules.

In another possible design, the method further includes: when determining that the current cycle is a $(K/n)^{th}$ cycle for receiving the to-be-encoded data, determining the second polynomial as the target polynomial; performing calculation based on a constant coefficient matrix and the target polynomial, to obtain the check sequence of the to-be-encoded data; and combining the to-be-encoded data and the check sequence of the to-be-encoded data, to obtain the codeword obtained by encoding the to-be-encoded data based on the forward error correction encoding scheme. A value of K/n is specifically a value obtained by rounding up a quotient of K/n. It should be understood that if the current cycle is the $(K/n)^{th}$ cycle for the encoder to receive the to-be-encoded data, it indicates that an input of a payload of one codeword has been completed. Correspondingly, if the current cycle is not the $(K/n)^{th}$ cycle for the encoder to receive the to-be-encoded data, it indicates that an input of a payload of one codeword is not completed.

In another possible design, when the length of the codeword obtained by encoding the to-be-encoded data based on the forward error correction encoding scheme is N, the constant coefficient matrix is an (N-K)×(N-K) first constant coefficient matrix; and when the length of the codeword obtained by encoding the to-be-encoded data based on the forward error correction encoding scheme is N+ΔN, the constant coefficient matrix is a (N+ΔN-K)×(N+ΔN-K) second constant coefficient matrix. The second constant coefficient matrix includes the first constant coefficient matrix.

In another possible design, the encoder supports encoding of at least one forward error correction code pattern, and each of the at least one forward error correction code pattern has a different error correction capability.

In another possible design, when a value of n is greater than a threshold, the method further includes: A register inserted into the feedforward module controls the feedforward module to complete calculation of a single-cycle polynomial in at least two clock cycles.

It should be understood that, for beneficial effect of the second aspect and any possible design manner of the second aspect, refer to descriptions of beneficial effect of the first aspect and any possible design manner of the first aspect. Details are not described herein again.

According to a third aspect, this application provides an encoding apparatus. In a possible design manner, the encoding apparatus is configured to perform any method provided in the second aspect. In this application, the encoding apparatus may be divided into functional modules according to the any method provided in the second aspect. For example, each functional module may be obtained through division based on each corresponding function, or two or more functions may be integrated into one processing module. For example, in this application, the encoding apparatus may be divided into a receiving unit, a calculation unit, and the like based on functions. For descriptions of possible technical solutions performed by the foregoing functional modules obtained through division and beneficial effect, refer to the technical solutions provided in the second aspect or the corresponding possible designs of the second aspect. Details are not described herein again.

According to a fourth aspect, this application provides a chip. The chip includes an encoding circuit, and the encoding circuit is configured to perform any method provided in the second aspect and any possible design manner of the second aspect, to encode to-be-encoded data based on a forward error correction encoding scheme.

According to a fifth aspect, this application provides a computer-readable storage medium. The computer-readable storage medium includes program instructions, and when the program instructions are run on a computer or a processor, the computer or the processor is enabled to perform any method provided in any possible implementation of the second aspect.

According to a sixth aspect, this application provides a computer program product. When the computer program product is run on an encoding apparatus, any method provided in any possible implementation of the second aspect is performed.

In this application, names of the encoder, the encoding apparatus, and the encoding circuit do not constitute any limitation on devices or functional modules. During actual implementation, these devices or functional modules may have other names. Each device or functional module falls within the scope defined by the claims and their equivalent technologies in this application, provided that a function of the device or functional module is similar to that described in this application.

## BRIEF DESCRIPTION OF DRAWINGS

FIG. 1 is a diagram of a current encoding circuit;
FIG. 2 is a diagram of another current encoding circuit;
FIG. 3 is a diagram of an application scenario according to an embodiment of this application;
FIG. 4 is a diagram of application of an FEC encoding technology in an Ethernet architecture according to an embodiment of this application;
FIG. 5 is another diagram of application of an FEC encoding technology in an Ethernet architecture according to an embodiment of this application;
FIG. 6 is a diagram of an architecture of an encoding system according to an embodiment of this application;
FIG. 7 is a diagram of a structure of a general-purpose computer according to an embodiment of this application;
FIG. 8 is a diagram of an encoder according to an embodiment of this application;
FIG. 9 is a diagram of a circuit structure of a feedforward circuit according to an embodiment of this application;
FIG. 10 is a diagram of structures of a feedforward circuit and a feedback circuit according to an embodiment of this application;
FIG. 11 is a diagram of a structure of an encoder according to an embodiment of this application;
FIG. 12 is a diagram of another structure of an encoder according to an embodiment of this application;
FIG. 13 is a diagram of another structure of an encoder according to an embodiment of this application;
FIG. 14 is a diagram of a feedforward circuit according to an embodiment of this application;
FIG. 15 is a diagram of a relationship between sets of polynomials indicating payloads in a case in which codeword lengths are different according to an embodiment of this application;
FIG. 16 is another diagram of an encoder according to an embodiment of this application;

FIG. 17 is a diagram of a relationship between constant coefficient sets in a case in which codeword lengths are different according to an embodiment of this application;

FIG. 18 is a diagram of another structure of an encoder according to an embodiment of this application;

FIG. 19 is a diagram of a structure of an encoder supporting hybrid encoding based on a plurality of code patterns according to an embodiment of this application;

FIG. 20 is a schematic flowchart of an encoding method according to an embodiment of this application;

FIG. 21 is a diagram of a constant coefficient matrix for an RS (544, 514, 15, 10) code pattern according to an embodiment of this application; and

FIG. 22 is a diagram of a structure of an encoding apparatus according to an embodiment of this application.

## DESCRIPTION OF EMBODIMENTS

To understand embodiments of this application more clearly, the following describes some terms or technologies used in embodiments of this application.

(1) Forward error correction (forward error correction, FEC)

FEC, also known as a forward error correction encoding technology, is an error control technology.

FEC is widely used in communication systems, to ensure accuracy of transmitted data. The basic idea of FEC is that a transmitter adds a check sequence with a specific length to to-be-sent data, to obtain a codeword (codeword) resulting from the to-be-sent data undergoing FEC encoding. Obviously, the codeword resulting from FEC encoding includes the to-be-sent data and the check sequence. After the codeword resulting from FEC encoding is transmitted to a receiver, if errors that occur in the data fall within a correctable range of the check sequence, the receiver corrects the errors based on the check sequence obtained through decoding. In this way, a bit error rate of the data can be reduced, and reliability of the communication system is improved.

Common FEC coding schemes include but are not limited to a Reed Solomon code (Reed Solomon code, RS code), a Hamming code (hamming code), a linear error correction code (low-density parity-check code), and the like.

The RS code is used as an example. The RS code, which is a specific implementation solution of the FEC technology, is specifically a linear block cyclic code. The RS code can be used to correct both random errors and burst errors, which is typically denoted as RS FEC.

Cyclic codes include but are not limited to the RS code, a cyclic redundancy check (cyclic redundancy check, CRC) code, a forward error correction code (Bose-Chaudhuri-Hocquenghem code, BCH code), a fire code (fire code), and the like. A basic unit for constituting a codeword of the cyclic code is referred to as a symbol (symbol). Therefore, a basic unit of the RS code for encoding calculation and decoding calculation is also a symbol. Usually, one symbol includes m bits, and m is an integer greater than or equal to 1. It should be understood that the symbol and the bit have a same meaning when m=1. For example, for the BCH code, the CRC code, and the fire code, a value of m is usually 1. For the RS code, a value of m is usually greater than 1. Therefore, a basic unit of a cyclic code may be bits, for example, for the case of the BCH code or the CRC code, or a basic unit of a cyclic code may be symbols, for example, for the case of the RS code.

Specifically, a length of an RS codeword is a number of symbols included in an RS code, and is usually represented by a letter N. A payload length in the RS codeword is a number of symbols included in a payload of one RS codeword, and is usually represented by a letter K. The payload of the RS codeword is raw data information protected by the RS code. For example, the payload of the RS codeword may be packet data to be transmitted in a communication network. This is not limited thereto. In addition, a redundant length of the RS codeword is a number of symbols included in a check sequence of one RS codeword, and is usually represented by a letter R. The symbol in the check sequence is also referred to as a redundant symbol. Obviously, R = N - K.

For ease of description, when the codeword length of the RS code is N and the payload length is K, the RS code may be denoted as an RS (N, K) code. For example, a code pattern of a KR4 RS code is denoted as RS (528, 514), indicating that a codeword length of the RS code is 528 and a payload length is 514. For another example, a code pattern of a KP4 RS code is denoted as RS (544, 514), indicating that a codeword length of the RS code is 544 and a codeword information length is 514.

An error correction capability of the RS code is a maximum number of symbols that can be successfully corrected and that are allowed to be erroneous in one RS codeword, and is usually represented by T. For the RS code, the error correction capability T = (N - K)/2 (that is, half of redundant symbols in the RS codeword). For example, for the code pattern of the KR4 RS code, the error correction capability T = (528 - 514)/2 = 7, that is, a maximum number of symbols that can be corrected and that are allowed to be erroneous in one RS codeword of the code pattern of the KR4 RS code is 7. For another example, for the code pattern of the KP4 RS code, the error correction capability T = (544 - 514)/2 = 15, that is, a maximum number of symbols that can be corrected and that are allowed to be erroneous in one RS codeword of the code pattern of the KP4 RS code is 15.

In addition, an encoding overhead of the FEC code is a ratio of the redundant length to the payload length in the codeword of the FEC code. In other words, the encoding overhead of the FEC code is (N-K)/K, or denoted as R/K.

The following briefly describe an encoding principle of the cyclic code by using the cyclic code with the codeword length of N and the payload length of K as an example.

The payload with a length of K may be represented as a polynomial M(x), and M(x) satisfies the following formula (1):

$$\text{Formula (1)} \quad M(x) = m_{K-1} \cdot x^{K-1} + m_{K-2} \cdot x^{K-2} + \cdots + m_1 \cdot x + m_0$$

Herein, m indicates a value of each symbol in the payload, and x indicates a location of each symbol in the payload.

A preset generator polynomial of the cyclic code in a finite field is denoted as g(x), and g(x) satisfies the following formula (2):

$$\text{Formula (2)} \quad g(x) = g_{N-K} \cdot x^{N-K} + g_{N-K-1} \cdot x^{N-K-1} + \cdots + g_1 \cdot x + g_0$$

Herein, g indicates a coefficient of the generator polynomial, and x indicates a location of each symbol in the check sequence.

Based on the polynomials shown in the formula (1) and the formula (2), an encoding process of the cyclic code may be implemented by dividing M(x) by g(x) to obtain a remainder p(x), where p(x) is a check sequence in the codeword of the cyclic code. Therefore, a codeword polynomial of one cyclic code satisfies the following formula (3):

$$\text{Formula (3)} \quad x^{N-K} \cdot M(x) = q(x) \cdot g(x) + p(x)$$

Herein, q(x) is a quotient of M(x) divided by g(x).

Further, the codeword polynomial of the cyclic code may be denoted as C(x), and C(x) satisfies the following formula (4):

$$\text{Formula (4)} \quad C(x) = x^{N-K} \cdot M(x) + p(x)$$

In this way, calculation may be performed according to the formula (4), to obtain the check sequence p(x), as shown in formula (5), in the codeword of the cyclic code, where MOD is a modulo operation.

$$\text{Formula (5)} \quad p(x) = \left( x^{N-K} \cdot M(x) \right) MOD g(x)$$

Therefore, the check sequence p(x) of the payload data is obtained, and the payload and the check sequence are combined, to obtain the codeword through encoding.

It should be noted that calculation performed on the polynomials in the foregoing encoding principle is calculation performed on the polynomials in the finite field.

The finite field is also referred to as a Galois field (galois field), is a field that includes only a limited number of elements, and may be represented by $GF(2^m)$, where $2^m$ indicates the elements in the finite field, and m is a positive integer. In the finite field, addition of polynomials is combining like terms and performing an exclusive OR operation on coefficients. For example, $x^4 + x^4 = 0$. Subtraction in the finite field is equivalent to addition, and no negative number exists in the finite field. For example, $x^4-x^4$ is equal to $x^4+x^4$, and $-x^3$ is equal to $x^3$.

Further, the code pattern of the RS code may also be represented by RS (N, K, T, m), where N is a code length of the RS codeword, K is a payload length in the RS codeword, T is an error correction capability of the RS code, and m indicates a finite field for performing RS encoding calculation.

(2) Feedforward circuit and feedback circuit

In embodiments of this application, when a signal output by a circuit at a moment t1 does not affect a signal output by the circuit at a moment t2 in time domain, the circuit is referred to as a feedforward circuit. When a signal output by a circuit at the moment t1 affects a signal output by the circuit at the moment t2 in time domain, the circuit is referred to as a feedback circuit, where the moment t2 is a moment after the moment t1. For example, the moment t1 is a moment before the moment t2.

(3) Cycle

The "cycle" in embodiments of this application is a cycle, and the "cycle" and the "cycle" in embodiments of this application may be replaced with each other.

Typically, one clock cycle is defined as one cycle.

(4) Parallelism

The parallelism in embodiments of this application is a number of symbols of to-be-encoded data that are allowed to be input to an encoder/encoding circuit in parallel in one cycle when the to-be-encoded data is input to the encoder/encoding circuit. For example, when the to-be-encoded data is input to the encoder/encoding circuit with a parallelism of n, it indicates that n symbols of the to-be-encoded data are allowed to be input to the encoder/encoding circuit in parallel in one cycle.

When the to-be-encoded data is input to the encoder/encoding circuit with the parallelism of n, and the to-be-encoded data includes K symbols, it indicates that the K symbols of the to-be-encoded data may be input to the encoder/encoding circuit in K/n cycles. A value of K/n is specifically a value obtained by rounding up a quotient of K/n. For example, when a value of K is 10 and a value of n is 4, a value of K/n is a value (namely, 3) obtained by rounding up a quotient (namely, 2.5) of 10/4.

In this case, in a scenario in which the to-be-encoded data is input to the encoder/encoding circuit with the parallelism of n, and the to-be-encoded data includes K symbols, it is assumed that K can be exactly divided by n. In a first cycle, a $1^{st}$ symbol to an $n^{th}$ symbol in the K symbols are allowed to be input to the encoder/encoding circuit in parallel; in a second cycle, an $(n+1)^{th}$ symbol to a $(2n)^{th}$ symbol in the K symbols are allowed to be input to the encoder/encoding circuit in parallel; ...; and in a $(K/n)^{th}$ cycle, a $(K-n+1)^{th}$ symbol to a $K^{th}$ symbol are allowed to be input to the encoder/encoding circuit in parallel.

(5) Other terms

In embodiments of this application, terms "first" and "second" do not indicate a sequence relationship, but are intended to distinguish between different objects. "First", "second", and the like mentioned in the following documents are also intended to distinguish between different packets and the like, and should not be understood as an indication or an implication of relative importance or an implication of a number of indicated technical features.

It should be further understood that sequence numbers of the processes do not mean execution sequences in embodiments of this application. The execution sequences of the processes should be determined based on functions and internal logic of the processes, and should not constitute any limitation on implementation processes of embodiments of this application.

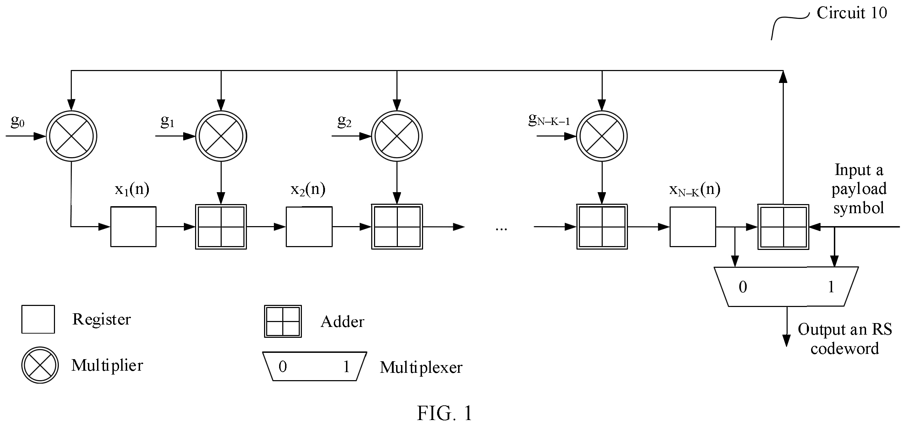

Currently, when FEC encoding is performed on to-be-transmitted data, because the encoding process based on the cyclic code is essentially a polynomial division calculation process, the encoding circuit can be implemented as a circuit shown in FIG. 1. As shown in FIG. 1, a cyclic code, namely, an RS (N, K) code, is used as an example. A circuit 10 may receive K payload symbols in series in K clock cycles. In a process of inputting the K payload symbols, a multiplexer points to "1", so that the K payload symbols input to the circuit 10 are sequentially output by the multiplexer in the K clock cycles, and meanwhile, the K payload symbols enter the circuit 10 for perform operations by using multipliers and adders in the circuit 10. When all the K payload symbols are input in the K clock cycles, values stored in N-K registers in the circuit 10 are symbols of check sequences. In this case, the multiplexer is switched to 0, and the circuit 10 sequentially outputs the symbols of the check sequences in N-K clock cycles, to obtain a complete RS codeword (including the K payload symbols and N-K check sequences).

However, when the to-be-transmitted data is input to the encoder in series, encoding efficiency is excessively low. Therefore, during actual implementation of encoding based on a cyclic code, an encoding architecture of parallel input is usually used. In other words, a plurality of payload symbols are input to the encoding circuit at a same moment, to improve encoding efficiency. For example, common parallel bit widths include 40 bits, 80 bits, and 160 bits. Therefore, when the parallel bit width is 40 bits, 4 payload symbols each with a length of 10 bits may be input to the encoding circuit at a same moment. When the parallel bit width is 80 bits, 8 payload symbols each with a length of 10 bits may be input to the encoding circuit at a same moment. When the parallel bit width is 160 bits, 16 payload symbols each with a length of 10 bits may be input to the encoding circuit at a same moment.

Current cyclic codes (for example, the RS code and the BCH code) are usually encoded by using the circuit structure shown in FIG. 1, that is, a linear feedback shift register (linear feedback shift register, LFSR) circuit. Based on the circuit, a parallel encoding calculation circuit can be deduced for a large bandwidth scenario. For example, based on the circuit structure shown in FIG. 1, when 32 symbols are input to the encoding circuit in parallel, it can be deduced that data calculation in the encoding circuit satisfies the following formula (6):

$$\text{Formula (6)} \begin{bmatrix} \text{REG14}_{\text{next}} \\ \text{REG13}_{\text{next}} \\ \vdots \\ \text{REG1}_{\text{next}} \end{bmatrix} = (G_{14\times14}, H'_{14\times18}) \cdot \begin{bmatrix} \text{REG14}_{\text{current}} + D_{32} \\ \text{REG13}_{\text{current}} + D_{31} \\ \vdots \\ \text{REG1}_{\text{current}} + D_{19} \\ D_{18} \\ \vdots \\ D_1 \end{bmatrix}$$

Herein, $\text{REGi}_{\text{current}}$ indicates a value of a current $i^{\text{th}}$ register, and $\text{REGi}_{\text{next}}$ indicates a value of an $i^{\text{th}}$ register in a next clock cycle. $D_j$ indicates a $j^{\text{th}}$ piece of data that is currently input, where i=1, 2, 3, ..., 14 (namely, a number of symbols of a check sequence), and j=1, 2, 3, ..., 32 (namely, parallelism). G is a $14\times14$ constant coefficient matrix, and may be represented as the following matrix (1). H' is a $14\times18$ constant coefficient matrix, and may be represented as the following matrix (2).

$$\text{Matrix (1)} \quad G_{14\times14} = \begin{bmatrix} g_{1,1} & g_{1,2} & \cdots & g_{1,14} \\ g_{2,1} & g_{2,2} & \cdots & g_{2,14} \\ \vdots & \vdots & \ddots & \vdots \\ g_{14,1} & g_{14,2} & \cdots & g_{14,14} \end{bmatrix}$$

$$\text{Matrix (2)} \quad H'_{14\times18} = \begin{bmatrix} h'_{1,1} & h'_{12} & \cdots & h'_{1,18} \\ h'_{2,1} & h'_{2,2} & \cdots & h'_{2,18} \\ \vdots & \vdots & \ddots & \vdots \\ h'_{14,1} & h'_{14,2} & \cdots & h'_{14,18} \end{bmatrix}$$

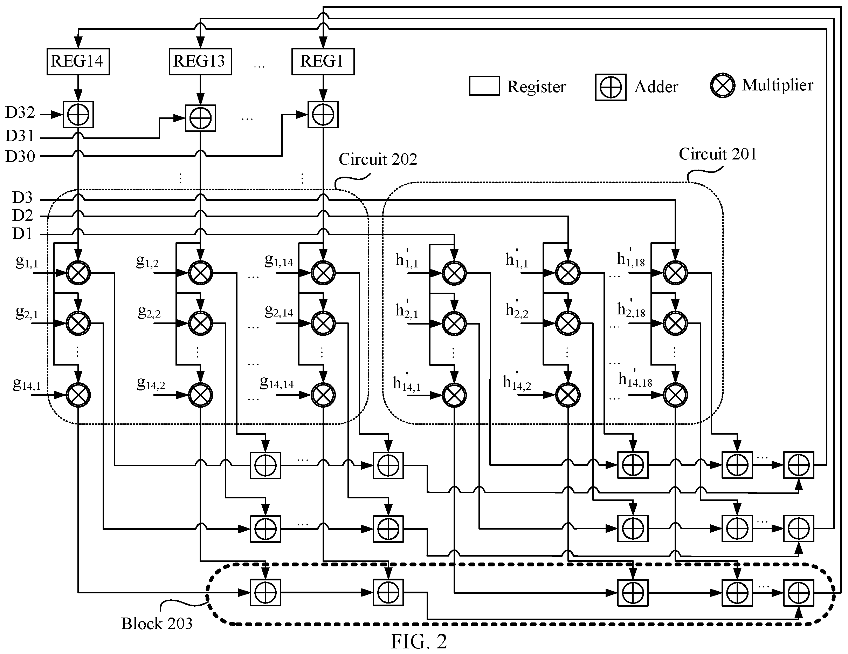

In addition, for encoding of RS (528, 514), when a payload is input to the encoding circuit with a parallelism of 32 symbols, the encoding circuit may be shown in FIG. 2. As shown in FIG. 2, for the 32 symbols (including D1 to D32) input to the encoding circuit in one clock cycle, D1 to D18 are input to a circuit 201 shown in FIG. 2, to implement an operation between the payload and the constant coefficient matrix H'. D19 to D32 each are added to a feedback value in a previous clock cycle and then sent to a circuit 202, to implement an operation between the payload and the constant coefficient matrix G. Further, 31 adders (for example, 31 adders included in a block 203 shown in FIG. 2) adds operation results of D1 to D18 and the constant coefficient matrix H' and operation results of D19 to D32 and the constant coefficient matrix G, to output an operation result of D1 to D32. The feedback value in the previous clock cycle is a result obtained through calculation based on D1 to D32 in the previous clock cycle. In other words, an operation result in one clock cycle is used as a feedback value in a next clock cycle to participate in an operation in the next clock cycle. A loop used to obtain the feedback value may be referred to as a feedback loop.

It can be learned that for a payload input to the encoder in each clock cycle, n-1 adders further need to perform an addition operation in a cascading manner (that is, a result of a previous adder is used as an input of a next adder) on operation results obtained based on the constant coefficient matrices, where n is a number of symbols of the payload that are input in parallel, or referred to as parallelism. Therefore, a length of the feedback loop in the encoder is strongly correlated with the parallelism at which the symbols of the payload are input to the encoder. In other words, a larger number of symbols of the payload that are input to the encoder in parallel indicates more addition operations (n-1 addition operations) on the feedback loop in the encoder, that is, a longer feedback loop in the encoder. In this case, when the number of symbols of the payload that are input in parallel is large, the encoding circuit shown in FIG. 2 cannot complete the n-1 addition operations in one clock cycle. Consequently, a timing closure may not be achieved in the feedback loop in the encoder.

In addition, for a plurality of FEC code patterns, for example, two RS FEC code patterns defined in the 802.3 standard: RS (528, 514) and RS (544, 514), coefficients of generator polynomials of the two code patterns in a finite field are completely different. Consequently, it is difficult to share circuit resources (adders and multipliers) for implementing encoding based on the two code patterns. Table 1 shows values of the coefficients of the generator polynomials of the RS (528, 514) code pattern and the RS (544, 514) code pattern. As shown in Table 1, 15 i∈[0, 15]) coefficients of the generator polynomial of the RS (528, 514) code pattern each are different from 31 (i∈[0, 30]) coefficients of the generator polynomial of the RS (544, 514) code pattern, where i is an integer. It should be understood that the coefficients of the generator polynomial are the coefficients g in the foregoing polynomial (2).

Table 1

| I | 0 | 1 | 2 | 3 | 4 | 5 | 6 | 7 | 8 | 9 | 10 |
|---|---|---|---|---|---|---|---|---|---|---|---|
| RS (528, 514) | 432 | 290 | 945 | 265 | 592 | 391 | 614 | 900 | 925 | 656 | 32 |
| RS (544, 514) | 523 | 834 | 128 | 158 | 185 | 127 | 392 | 193 | 610 | 788 | 361 |
| I | 11 | 12 | 13 | 14 | 15 | 16 | 17 | 18 | 19 | 20 | 21 |
| RS (528, 514) | 701 | 6 | 904 | 1 | | | | | | | |
| RS (544, 514) | 883 | 503 | 942 | 385 | 495 | 720 | 94 | 132 | 593 | 249 | 292 |
| I | 22 | 23 | 24 | 25 | 26 | 27 | 28 | 29 | 30 | | |
| RS (528, 514) | | | | | | | | | | | |
| RS (544, 514) | 565 | 108 | 1 | 552 | 230 | 187 | 552 | 575 | 1 | | |

In view of this, embodiments of this application provide an encoder. When the encoder performs encoding, a feedforward module and a feedback module in the encoder perform calculation, to obtain a target polynomial indicating to-be-encoded data. The feedforward module is configured to receive the to-be-encoded data with a parallelism of n symbols per cycle, and perform calculation in a finite field based on a symbol of the to-be-encoded data received in a current cycle, to obtain a single-cycle polynomial corresponding to the current cycle. The feedback module is configured to perform calculation based on the single-cycle polynomial, received from the feedforward module, corresponding to the current cycle and a first polynomial indicating a symbol received in a historical cycle, to obtain the target polynomial indicating the to-be-encoded data. In this manner, the feedback module in the encoder is decoupled from parallelism at which the to-be-encoded data is input to the encoder. In other words, even if a large number of symbols of the to-be-encoded data is input to the encoder per cycle, a length of the feedback module does not increase accordingly, to avoid a technical problem in which a timing closure is not achieved in the feedback module.

The to-be-encoded data may be data to be transmitted in a communication network, or data to be stored in a storage system (for example, a distributed storage system). This is not limited. The single-cycle polynomial indicates a symbol received by the feedforward module in one cycle.

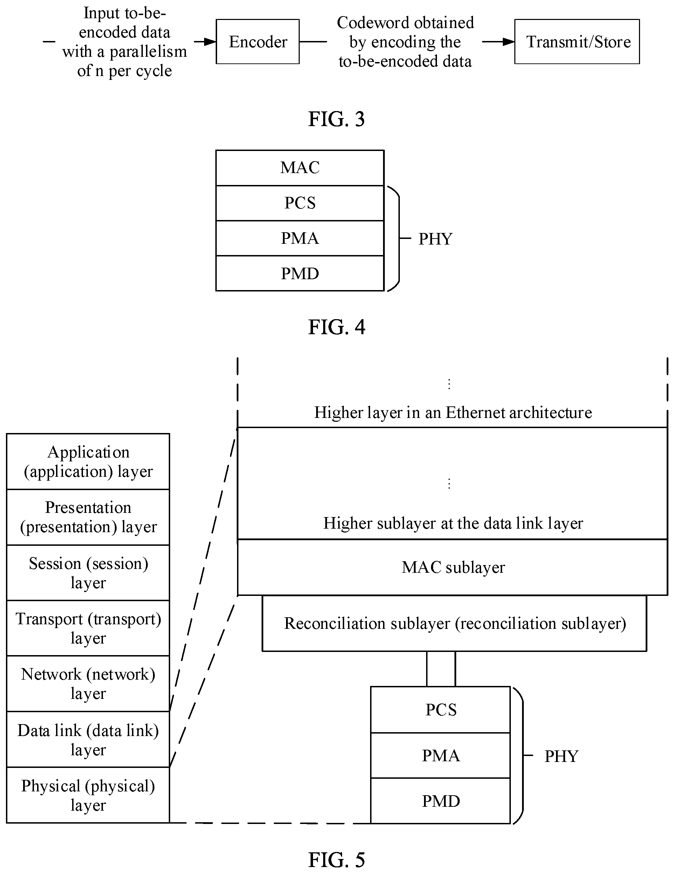

FIG. 3 is a diagram of an application scenario according to an embodiment of this application. As shown in FIG. 3, to-be-encoded payload data is input, with a parallelism of n symbols per cycle, to the encoder provided in embodiments of this application. It may also be understood as that the to-be-encoded payload data is input, at parallelism n per cycle, to the encoder provided in embodiments of this application. Then, the encoder performs forward error correction encoding on the to-be-encoded payload data, and outputs a codeword obtained by encoding the to-be-encoded data. The codeword includes a payload and a check sequence, and the payload is the to-be-encoded data. Further, the codeword obtained through encoding may be transmitted or stored. It should be understood that, because a technical risk in which a timing closure is not achieved in the feedback module in the encoder provided in embodiments of this application does not occur, the encoder provided in embodiments of this application supports forward error correction encoding performed on the to-be-encoded payload data at high parallelism in a large bandwidth scenario.

Optionally, a process in which the encoder provided in embodiments of this application encodes the data is usually applied to a media access control (media access control, MAC) sublayer and a physical layer (physical layer, PHY layer) in an Ethernet architecture.

For example, FIG. 4 is a diagram of application of an FEC encoding technology in an Ethernet architecture according to an embodiment of this application. FIG. 4 shows a hierarchical architecture of the Ethernet. The Ethernet architecture is divided into a MAC sublayer, a physical coding sublayer (physical coding sublayer, PCS), a physical medium attachment (physical medium attachment, PMA) sublayer, and a physical medium dependent (physical medium dependent, PMD) sublayer based on functions. The PCS, the PMA sublayer, and the PMD sublayer form a PHY layer. The FEC encoding technology is applied to the MAC sublayer and the PHY layer in the Ethernet architecture shown in FIG. 4. For example, CRC encoding is usually applied to the MAC sublayer in the Ethernet architecture shown in FIG. 4, and RS encoding is usually applied to the PCS sublayer in the Ethernet architecture shown in FIG. 4. Details are not described.

For another example, FIG. 5 is another diagram of application of an FEC encoding technology in an Ethernet architecture according to an embodiment of this application. As shown in FIG. 5, the standard Ethernet architecture includes an application (application) layer, a presentation (presentation) layer, a session (session) layer, a transport (transport) layer, a network (network) layer, a data link (data link) layer, and a physical (physical) layer. The data link layer includes a MAC sublayer and a reconciliation sublayer (reconciliation sublayer). The reconciliation sublayer is a special sublayer (equivalent to a top layer of the physical layer) that is between MII signaling and the MAC sublayer and that is responsible for processing a translating or mapping requirement. The physical layer includes a PCS sublayer, a PMA sublayer, and a PMD sublayer. The FEC encoding technology provided in embodiments of this application is applied to the physical layer and the MAC sublayer of the data link layer. For example, an RS encoder provided in embodiments of this application may be deployed at the PCS sublayer of the physical layer shown in FIG. 5.

Optionally, physical implementation of the encoder includes but is not limited to a chip, an integrated circuit, a computing apparatus or computing device having a computing processing capability, or the like. For example, the chip includes but is not limited to a programmable logic device (complex programmable logic device, CPLD), a field programmable gate array (Field Programmable Gate Array, FPGA), a programmable array logic (programmable array logic, PAL) device, a generic array logic (generic array logic, GAL) device, and a network interface card, a microcontroller unit (microcontroller unit, MCU). The integrated circuit includes but is not limited to an application-specific integrated circuit (application-specific integrated circuit, ASIC) and the like. The computing device includes but is not limited to a general-purpose computer, a notebook computer, a tablet computer, and the like.

Embodiments of this application further provide an encoding system. The system includes a controller and the encoder provided in embodiments of this application. The controller is configured to control inputting of symbols of to-be-encoded data into the encoder in parallel. The encoder performs forward error correction encoding on the to-be-encoded data based on the received to-be-encoded data. For a specific process, refer to the following descriptions. Details are not described.

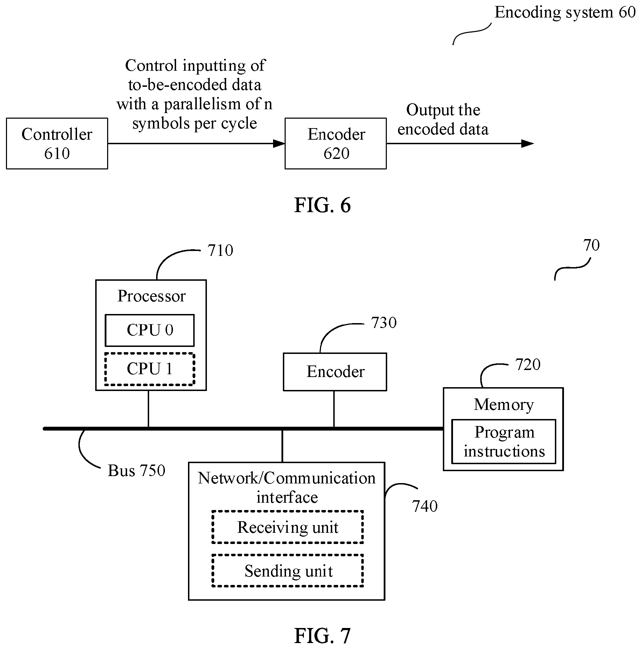

For example, FIG. 6 is a diagram of an architecture of an encoding system 60 according to an embodiment of this application. As shown in FIG. 6, the encoding system 60 includes a controller 610 and an encoder 620. The controller 610 controls inputting of symbols of to-be-encoded data into the encoder 620 with a parallelism of n symbols per cycle, where n is a positive integer. The encoder 620 performs forward error correction encoding on the to-be-encoded data based on the received to-be-encoded data, and outputs encoded data. For a specific process, refer to the following descriptions. Details are not described.

Optionally, the controller and the encoder in the encoding system may be integrated into one device (for example, a SerDes chip (SerDes is short for SERializer (serializer)/DESerializer (deserializer))), or may be integrated into different devices. This is not limited. The device may be a chip, an integrated circuit, a computing apparatus or computing device having a computing processing capability, or the like. This is not limited. For detailed descriptions of the "chip, integrated circuit, or computing apparatus or computing device having a computing processing capability", refer to the foregoing descriptions. Details are not described again.

For example, the encoding system is implemented by a general-purpose computer. FIG. 7 is a diagram of a structure of a general-purpose computer 70 according to an embodiment of this application. As shown in FIG. 7, the general-purpose computer 70 includes a processor 710, a memory 720, an encoder 730, a network/communication interface 740, and a bus 750. The processor 710, the memory 720, the encoder 730, and the network/communication interface 740 are connected through the bus 750.

The processor 710 is a control center of the general-purpose computer 70, and may be a general-purpose central processing unit (central processing unit, CPU), or the processor 710 may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or transistor logic device, a discrete hardware component, a graphics processing unit (graphics processing unit, GPU), a neural network processing unit (neural network processing unit, NPU), a tensor processing unit (tensor processing unit, TPU) or an artificial intelligent (artificial intelligent) chip, a data processing unit (data processing unit, DPU), or the like.

For example, the processor 710 includes one or more CPUs, for example, a CPU 0 and a CPU 1 shown in FIG. 7.

In addition, the processor 710 is configured to implement a function of the controller in the foregoing encoding system, to control inputting of the to-be-encoded data to the encoder in parallel.

The memory 720 is configured to store program instructions or data to be accessed by an application process. The processor 710 may execute the program instructions in the memory 720. For example, the memory 720 may be configured to store to-be-encoded data and data that has been encoded.

The memory 720 includes a volatile memory or a non-volatile memory, or may include both a volatile memory and a non-volatile memory. The volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. By way of example rather than limitation, a plurality of forms of RAMs may be used, for example, a static random access memory (static RAM, SRAM), a dynamic random access memory (dynamic random access memory, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchronous link dynamic random access memory (synchlink DRAM, SLDRAM), and a direct rambus random access memory (direct rambus RAM, DR RAM). The non-volatile memory may be a storage class memory (storage class memory, SCM), a solid-state drive (solid-state drive, SSD), a hard disk drive (hard disk drive, HDD), or the like. The storage class memory may be, for example, a non-volatile memory (non-volatile memory, NVM), a phase-change memory (phase-change memory, PCM), or a persistent memory.

In a possible implementation, the memory 720 is independent of the processor 710. The memory 720 is connected to the processor 710 through the bus 750, and is configured to store data, instructions, or program code. For example, the processor 710 controls inputting of the to-be-encoded data stored in the memory 720 to the encoder in parallel, and writes the data encoded by the encoder into the memory 720.

In another possible implementation, the memory 720 and the processor 710 are integrated together.

The encoder 730 is the encoder in the foregoing encoding system, and is configured to perform forward error correction encoding on the received to-be-encoded data, and output a codeword obtained through encoding. For detailed descriptions of the encoder, refer to the following descriptions. Details are not described herein.

The network/communication interface 740 is configured to connect the general-purpose computer 70 to another device (for example, a device configured to receive the encoded data) via a communication network. The communication network may be the Ethernet, a radio access network (radio access network, RAN), a wireless local area network (wireless local area network, WLAN), or the like. The network/communication interface 740 includes a receiving unit configured to receive data/a packet and a sending unit configured to send data/a packet.

The bus 750 may be an industry standard architecture (industry standard architecture, ISA) bus, a peripheral component interconnect (peripheral component interconnect, PCI) bus, a peripheral component interconnect express (peripheral component interconnect express, PCIe) bus, a compute express link (compute express link, CXL), an extended industry standard architecture (extended industry standard architecture, EISA) bus, or the like. The bus may be classified into an address bus, a data bus, a control bus, or the like. For ease of representation, only one bold line is used for representation in FIG. 7, but this does not mean that there is only one bus or only one type of bus.

It should be noted that the structure shown in FIG. 7 does not constitute a limitation on the general-purpose computer 70. In addition to the components shown in FIG. 7, the general-purpose computer 70 may include more or fewer components than those shown in FIG. 7, a combination of some components, or a different component layout.

The following describes in detail the encoder provided in embodiments of this application by using an example in which a FEC code is an RS (N, K) code with reference to the accompanying drawings. RS (N, K) indicates that a length of a codeword obtained through encoding is N and a payload length is K. Correspondingly, a length of a check sequence of the codeword obtained through encoding is N-K. N and K are both integers, and N is greater than K.

It should be understood that, based on a definition of the RS (N, K) code, a codeword C(x) obtained by encoding the RS code satisfies the mathematical constraint in the foregoing formula (4). Therefore, a root $\alpha^i$ of a generator polynomial in a finite field is substituted into the formula (4), to obtain a formula (7), where $i \in [0, N-K-1]$.

$$\text{Formula (7)} \quad C(\alpha^i) = (\alpha^i)^{N-K} \cdot M(\alpha^i) + p(\alpha^i) = 0, \text{ where } i = 0, 1, 2, ..., N-K-1$$

It should be further understood that the polynomial operation in embodiments of this application is an operation of a polynomial in the finite field. In view of this, a formula (8) may be obtained according to $(\alpha^i)^{N-K} \cdot M(\alpha^i) + p(\alpha^i) = 0$ in the formula (7).

$$\text{Formula (8)} \quad p(\alpha^i) = (\alpha^i)^{N-K} \cdot M(\alpha^i), \text{ where } i = 0,1,2,....,N-K-1$$

In addition, it can be learned from the foregoing that a polynomial p(x) used to obtain the check sequence is a remainder obtained by dividing the polynomial M(x) indicating a payload by the generator polynomial g(x). Therefore, based on the polynomial (1) and the polynomial (2) described above, the polynomial p(x) satisfies the following formula (9):

$$\text{Formula (9)} \quad p(x) = p_0 + p_1 x + p_2 x^2 + \cdots + p_{N-K-1} x^{N-K-1}$$

Therefore, the root $\alpha^i$ of the generator polynomial in the finite field is substituted into the formula (9) and the formula (8) is used, to obtain the following formula (10), where $i \in [0, N-K-1]$.

Formula (10)

$$\begin{cases} p_0 + p_1\alpha^0 + p_2(\alpha^0)^2 + \cdots + p_{N-K-1}(\alpha^0)^{N-K-1} = (\alpha^0)^{N-K} \cdot M(\alpha^0) \\ p_0 + p_1\alpha^1 + p_2(\alpha^1)^2 + \cdots + p_{N-K-1}(\alpha^1)^{N-K-1} = (\alpha^1)^{N-K} \cdot M(\alpha^1) \\ \qquad\qquad\vdots \\ p_0 + p_1\alpha^{N-K-1} + p_2(\alpha^{N-K-1})^2 + \cdots + p_{N-K-1}(\alpha^{N-K-1})^{N-K-1} = (\alpha^{N-K-1})^{N-K} \cdot M(\alpha^{N-K-1}) \end{cases}$$

Further, $(\alpha^0)^{N-K}$ in the formula (10) is moved to the left of the formula (10), and an operation is converted into a matrix operation, to obtain the following formula (11):

Formula (11)
$$\begin{bmatrix} (\alpha^0)^{K-N} & 0 & 0 & \cdots & 0 \\ 0 & (\alpha^1)^{K-N} & 0 & \cdots & 0 \\ 0 & 0 & (\alpha^2)^{K-N} & \cdots & 0 \\ \vdots & \vdots & \vdots & \ddots & \vdots \\ 0 & 0 & 0 & \cdots & (\alpha^{N-K-1})^{K-N} \end{bmatrix} \cdot$$

$$\begin{bmatrix} (\alpha^0)^{N-K-1} & (\alpha^0)^{N-K-2} & \cdots & (\alpha^0)^1 & 1 \\ (\alpha^1)^{N-K-1} & (\alpha^1)^{N-K-2} & \cdots & (\alpha^1)^1 & 1 \\ (\alpha^2)^{N-K-1} & (\alpha^2)^{N-K-2} & \cdots & (\alpha^2)^1 & 1 \\ \vdots & \vdots & \ddots & \vdots & \vdots \\ (\alpha^{N-K-1})^{N-K-1} & (\alpha^{N-K-1})^{N-K-2} & \cdots & (\alpha^{N-K-1})^1 & 1 \end{bmatrix} \cdot \begin{bmatrix} p_{N-K-1} \\ p_{N-K-2} \\ \vdots \\ p_1 \\ p_0 \end{bmatrix} = \begin{bmatrix} M(\alpha^0) \\ M(\alpha^1) \\ M(\alpha^2) \\ \vdots \\ M(\alpha^{N-K-1}) \end{bmatrix}$$

After the matrix operation is performed on the formula (11), the following formula (12) is obtained:

Formula (12)
$$\begin{bmatrix} (\alpha^0)^{-1} & (\alpha^0)^{-2} & \cdots & (\alpha^0)^{K-N+1} & (\alpha^0)^{K-N} \\ (\alpha^1)^{-1} & (\alpha^1)^{-2} & \cdots & (\alpha^1)^{K-N+1} & (\alpha^1)^{K-N} \\ (\alpha^2)^{-1} & (\alpha^2)^{-2} & \cdots & (\alpha^2)^{K-N+1} & (\alpha^2)^{K-N} \\ \vdots & \vdots & \ddots & \vdots & \vdots \\ (\alpha^{N-K-1})^{-1} & (\alpha^{N-K-1})^{-2} & \cdots & (\alpha^{N-K-1})^{K-N+1} & (\alpha^{N-K-1})^{K-N} \end{bmatrix} \cdot \begin{bmatrix} p_{N-K-1} \\ p_{N-K-2} \\ \vdots \\ p_1 \\ p_0 \end{bmatrix} =$$

$$\begin{bmatrix} M(\alpha^0) \\ M(\alpha^1) \\ M(\alpha^2) \\ \vdots \\ M(\alpha^{N-K-1}) \end{bmatrix}$$

Symbols $\Theta$, $\Phi$, and $\Omega$ are introduced on the basis of the formula (12), and when RS (N, K) encoding is implemented, $\Theta_{N,K}$ satisfies a formula (13), $\Phi_{N,K}$ satisfies a formula (14), and $\Omega_{N,K}$ satisfies a formula (15):

Formula (13)  $\Theta_{N,K} =$
$$\begin{bmatrix} (\alpha^0)^{-1} & (\alpha^0)^{-2} & \cdots & (\alpha^0)^{K-N+1} & (\alpha^0)^{K-N} \\ (\alpha^1)^{-1} & (\alpha^1)^{-2} & \cdots & (\alpha^1)^{K-N+1} & (\alpha^1)^{K-N} \\ (\alpha^2)^{-1} & (\alpha^2)^{-2} & \cdots & (\alpha^2)^{K-N+1} & (\alpha^2)^{K-N} \\ \vdots & \vdots & \ddots & \vdots & \vdots \\ (\alpha^{N-K-1})^{-1} & (\alpha^{N-K-1})^{-2} & \cdots & (\alpha^{N-K-1})^{K-N+1} & (\alpha^{N-K-1})^{K-N} \end{bmatrix}^{-1}$$

$$= \begin{bmatrix} \theta_{1,1} & \theta_{1,2} & \cdots & \theta_{1,N-K} \\ \theta_{2,1} & \theta_{2,2} & \cdots & \theta_{2,N-K} \\ \vdots & \vdots & \ddots & \vdots \\ \theta_{N-K,1} & \theta_{N-K,2} & \cdots & \theta_{N-K,N-K} \end{bmatrix}$$

$$\text{Formula (14)} \quad \Phi_{N,K} = \begin{bmatrix} M(\alpha^0) \\ M(\alpha^1) \\ M(\alpha^2) \\ \vdots \\ M(\alpha^{N-K-1}) \end{bmatrix}$$

$$\text{Formula (15)} \quad \Omega_{N,K} = \begin{bmatrix} p_{N-K-1} \\ p_{N-K-2} \\ \vdots \\ p_1 \\ p_0 \end{bmatrix}$$

It can be learned that, in the RS (N, K) code pattern, $\Theta_{N,K}$ indicates a set of $(N-K)^2$ constant coefficients, $\Phi_{N,K}$ indicates a set of polynomials of the payload in the RS codeword, and $\Omega_{N,K}$ indicates the check sequence of the RS codeword. In addition, it can be learned from the formula (12), the formula (13), the formula (14), and the formula (15) that $\Theta_{N,K}$, $\Phi_{N,K}$, and $\Omega_{N,K}$ satisfy a mathematical constraint relationship: $\Omega_{N,K} = \Theta_{N,K} \times \Phi_{N,K}$.

Therefore, a process of calculating the check sequence of the RS codeword in the RS encoding process may be converted into a process of calculating $\Theta_{N,K} \times \Phi_{N,K}$. During specific implementation, corresponding modules need to separately implement $\Theta_{N,K}$ and $\Phi_{N,K}$. A specific module for implementing $\Phi_{N,K}$ includes (N-K) modules (which are referred to as polynomial evaluation modules below) for calculating the polynomial $M(\alpha^i)$ that indicates the payload, where $i \in [0, N-K-1]$. $\Theta_{N,K}$ is used to implement calculation of the $(N-K)^2$ constant coefficients: $\theta_{j,1}, \theta_{j,2}, \theta_{j,3}, \ldots,$ and $\theta_{j,N-K}$, where $j=1, 2, \ldots, N-K$.

$M(\alpha^i)$ is the polynomial that indicates the payload in the finite field. $\alpha^i$ is the root of the generator polynomial in the finite field. Therefore, $\alpha^i$ is substituted into the formula (1), to obtain $M(\alpha^i)$ that satisfies a formula (16):

$$\text{Formula (16)} \quad M(\alpha^i) = m_{K-1} \cdot (\alpha^i)^{K-1} + m_{K-2} \cdot (\alpha^i)^{K-2} + \cdots + m_1 \cdot (\alpha^i) + m_0$$

In view of this, in embodiments of this application, a module for calculating the polynomial $M(\alpha^i)$ that indicates the payload is referred to as a polynomial evaluation module. The polynomial evaluation module includes the feedforward module and the feedback module described above. Optionally, the feedforward module and the feedback module may be implemented by using hardware circuits, or implemented by using a combination of software and a hardware circuit. This is not limited. For example, the feedforward module may be implemented by using a feedforward circuit, and the feedback module may be implemented by using a feedback circuit.

For ease of description, in the following embodiments of this application, an example in which the feedforward module in the encoder is a feedforward circuit and the feedback module in the encoder is a feedback circuit is used for description. In this case, the polynomial evaluation module includes the feedforward circuit and the feedback circuit. Therefore, in the following, the polynomial evaluation module is referred to as a polynomial evaluation circuit.

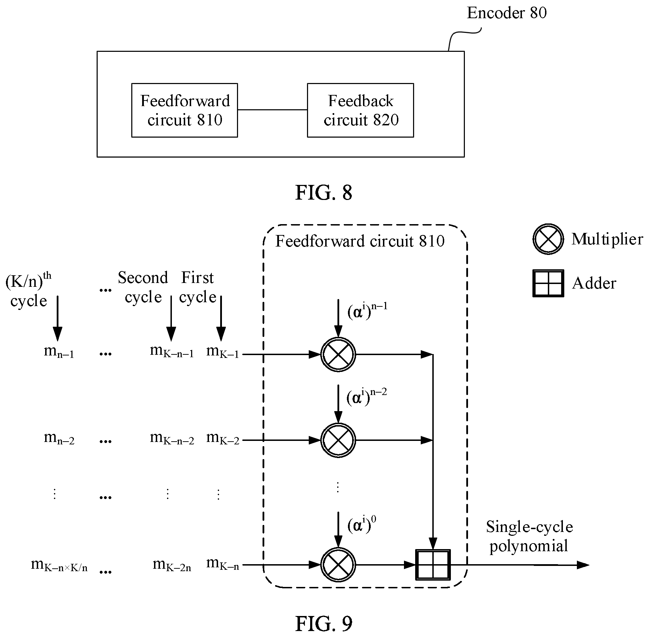

FIG. 8 is a diagram of an encoder according to an embodiment of this application. As shown in FIG. 8, an encoder 80 includes a feedforward circuit 810 and a feedback circuit 820.

The feedforward circuit 810 is configured to receive to-be-encoded data with a parallelism of n symbols per cycle. In this way, the feedforward circuit 810 can receive the to-be-encoded data in K/n cycles. The to-be-encoded data (namely, payload data in a codeword obtained through encoding) includes K symbols, both n and K are positive integers, and K is greater than or equal to n. A value of K/n is specifically a value obtained by rounding up a quotient of K/n. Therefore, a $(K/n)^{th}$ cycle for receiving the to-be-encoded data is a last cycle for receiving the K symbols in the to-be-encoded data.

It should be understood that a controller in an encoding system controls inputting of the to-be-encoded data to the feedforward circuit 810 in the encoder 81 with the parallelism of n symbols per cycle when encoding of the to-be-encoded data including the K symbols starts. For detailed descriptions of the controller, refer to the foregoing descriptions. Details are not described again. In response, the feedforward circuit 810 receives the to-be-encoded data with the parallelism of n symbols per cycle, and receives the to-be-encoded data in the K/n cycles.

The feedforward circuit 810 is further configured to perform calculation in a finite field based on a symbol of the to-be-encoded data received in a current cycle, to obtain a single-cycle polynomial corresponding to the current cycle. The single-cycle polynomial indicates a symbol received by the feedforward module in one cycle.

Specifically, the feedforward circuit 810 includes n multipliers, and the n multipliers are configured to receive n symbols of the to-be-encoded data that are input to the feedforward circuit 810 with the parallelism of n. It can be learned from the formula (16) that the n multipliers are configured to respectively multiply the received n symbols by a coefficient

$(\alpha^i)^u$, and then n-1 adders sum up multiplication results, to obtain a polynomial indicating the n symbols input to the feedforward circuit 810 in a single cycle, and the polynomial is denoted as a single-cycle polynomial, where $u \in [0, n-1]$.

It should be understood that an operation implemented by the feedforward circuit 810 is an operation in the finite field. $\alpha^1$ is a root of a generator polynomial used by the feedforward circuit 810 when performing the operation in the finite field, and $i \in [0, N-K-1]$. $\alpha$ is a root of a primitive polynomial in the finite field. A finite field $GF(2^{10})$ is used as an example. The primitive polynomial in the finite field is $x^{10}+x^3+1$, and $\alpha$ is the root of the primitive polynomial, so that a value of $\alpha$ can be solved based on the primitive polynomial. Correspondingly, a value of $\alpha^i$ can also be obtained through calculation.

Further, the feedforward circuit may output K/n single-cycle polynomials in the K/n cycles based on the K symbols of the to-be-encoded data that are input to the feedforward circuit 810 in the K/n cycles. In other words, the feedforward circuit 810 can obtain, through calculation in the finite field, a polynomial (namely, a single-cycle polynomial) that indicates a symbol received in each cycle.

FIG. 9 is a diagram of a circuit structure of a feedforward circuit according to an embodiment of this application. As shown in FIG. 9, m indicates a symbol of the to-be-encoded data.

As shown in FIG. 9, in a first cycle, the feedforward circuit 810 receives a 1st symbol to an nth symbol: $m_{K-1}$, $m_{K-2}$, ..., and $m_{K-n}$ of the to-be-encoded data. The multiplier multiplies $m_{K-1}$ by a coefficient $(\alpha^i)^{n-1}$, the multiplier multiplies $m_{K-2}$ by a coefficient $(\alpha^i)^{n-2}$, ..., and the multiplier multiplies $m_{K-n}$ by a coefficient $(\alpha^i)^0$. Then, the n-1 adders sum up multiplication results of the n multipliers, to obtain a single-cycle polynomial indicating the n symbols input in the first cycle, that is, to obtain a single-cycle polynomial corresponding to the first cycle, where the single-cycle polynomial is denoted as $B_{1a}$.

Similarly, in a second cycle, the feedforward circuit 810 receives an $(n+1)^{th}$ symbol to a $(2n)^{th}$ symbol: $m_{K-n-1}$, $m_{K-n-2}$, ..., and $m_{K-2n}$ of the to-be-encoded data. The multiplier multiplies $m_{K-n-1}$ by the coefficient $(\alpha^i)^{n-1}$, the multiplier multiplies $m_{K-n-2}$ by the coefficient $(\alpha^i)^{n-2}$, ..., and the multiplier multiplies $m_{K-2n}$ by the coefficient $(\alpha^i)^0$. Then, the n-1 adders sum up multiplication results of the n multipliers, to obtain a single-cycle polynomial indicating the n symbols input in the second cycle, that is, to obtain a single-cycle polynomial corresponding to the second cycle, where the single-cycle polynomial is denoted as $B_{2a}$.

Similarly, at the $(K/n)^{th}$ cycle, the feedforward circuit 810 receives a $([(K/n)-1]\times n+1)^{th}$ symbol to a $((K/n)\times n)^{th}$ symbol: $m_{n-1}$, $m_{n-2}$, ..., and $m_{K-(K/n)\times n}$ of the to-be-encoded data, where $m_{K-(K/n)\times n}$ is $m_0$. The multiplier multiplies $m_{n-1}$ by the coefficient $(\alpha^i)^{n-1}$, the multiplier multiplies $m_{n-2}$ by the coefficient $(\alpha^i)^{n-2}$, ..., and the multiplier multiplies $m_0$ by the coefficient $(\alpha^i)^0$. Then, the n-1 adders sum up multiplication results of the n multipliers, to obtain a single-cycle polynomial indicating the n symbols input in the $(K/n)^{th}$ cycle, that is, to obtain a single-cycle polynomial corresponding to the $(K/n)^{th}$ cycle, where the single-cycle polynomial is denoted as $B_{(K/n)a}$.

It should be understood that, in the process of inputting the to-be-encoded data with a length of K symbols with the parallelism of n, the $(K/n)^{th}$ cycle is the last cycle. In the $(K/n)^{th}$ cycle, when a number of symbols (denoted as "payload symbol in the last cycle") of the to-be-encoded data that are input to the feedforward circuit 810 is less than n, the n symbols including the payload symbol in the last cycle may be input to the encoder in a manner in which the payload symbol in the last cycle is set to a low-order symbol in the n symbols that are input in the $(K/n)^{th}$ cycle, and bits in the n symbols that are input in the $(K/n)^{th}$ cycle other than the bit for setting the payload symbol in the last cycle are padded with 0.

The feedback circuit 820 is configured to receive the single-cycle polynomial, corresponding to the current cycle, output by the feedforward circuit, and perform calculation in the finite field based on the single-cycle polynomial corresponding to the current cycle and a first polynomial indicating a symbol received in a historical cycle, to obtain a second polynomial. The second polynomial indicates symbols received from an initial cycle to the current cycle, and the second polynomial is used to determine a target polynomial indicating the to-be-encoded data. Herein, the initial cycle is a first cycle for the feedforward circuit to receive the to-be-encoded data, and the historical cycle is a cycle that is located before the current cycle in a process in which the feedforward circuit receives the to-be-encoded data. For example, it is assumed that the current cycle is a third cycle in the process of receiving the to-be-encoded data. In this case, the historical cycle includes the first cycle and a second cycle for receiving the to-be-encoded data. For another example, it is assumed that the current cycle is a fifth cycle in the process of receiving the to-be-encoded data. In this case, the historical cycle includes the first cycle, a second cycle, a third cycle, and a fourth cycle for receiving the to-be-encoded data.

Specifically, the feedback circuit 820 includes an adder and a multiplier. An implementation principle of the feedback circuit 820 is as follows: When the first polynomial is represented as $A_1$, the second polynomial is represented as $A_2$, and the single-cycle polynomial indicating the symbol received in the current cycle is represented as $A_{2a}$, the feedback circuit 820 is configured to obtain the second polynomial $A_2$ through calculation according to the following formula (17):

$$\text{Formula (17)} \quad A_2 = A_1 \times (\alpha^i)^n + A_{2a}$$

It should be understood that an operation implemented by the feedback circuit 820 is an operation in the finite field. $\alpha^i$ in the formula (17) is a root of a generator polynomial used by the feedback circuit 820 when performing the operation in the finite field, and $i \in [0, N-K-1]$. $\alpha$ is a root of a primitive polynomial in the finite field. For a process of solving $\alpha$, refer to the foregoing descriptions. Details are not described again.

It should be noted that if the current cycle is the $(K/n)^{th}$ cycle and a number of payload symbols in the last cycle is less than the parallelism n, when the second polynomial is calculated in the $(K/n)^{th}$ cycle, a value of n in $(\alpha^i)^n$ is the number of payload symbols in the last cycle. For example, the value of the parallelism n is 10, and a number of payload symbols (namely, the payload symbols in the last cycle) of the to-be-encoded data that are input in the $(K/n)^{th}$ cycle is 2. When the second polynomial corresponding to the $(K/n)^{th}$ cycle is calculated, the value of n in $(\alpha^i)^n$ is 2.

It can be learned that, although a calculation result of the feedback circuit 820 in the current clock cycle participates in an operation in a next clock cycle in terms of a timing, a length of the feedback circuit 820 is irrelevant to the parallelism at which the feedforward circuit 810 receives the to-be-encoded data. In this way, even if the to-be-encoded data is input to the encoder at the high parallelism in a large bandwidth scenario, the length of the feedback circuit in the encoder is not affected. In other words, the encoder provided in embodiments of this application implements decoupling between the parallelism at which the to-be-encoded data is input to the encoder and the feedback circuit in the encoder. Therefore, in a large bandwidth scenario, when the to-be-encoded data is input to the encoder at the high parallelism, a technical problem in which a timing closure is not achieved does not occur. This is because the addition and multiplication operations that need to be completed by the feedback circuit in the encoder provided in embodiments of this application can be completed in one clock cycle.

Further, the feedforward circuit 810 receives the to-be-encoded data in the K/n cycles, and outputs K/n single-cycle polynomials. The feedback circuit may perform (K/n)-1 iteration calculations based on all the single-cycle polynomials output by the feedforward circuit 810, to obtain, through calculation, the polynomial indicating the to-be-encoded data, where the polynomial is denoted as a target polynomial. Further, the target polynomial is used to generate a check sequence of the to-be-encoded data, the check sequence of the to-be-encoded data is used to check and correct the to-be-encoded data, and a codeword obtained by encoding the to-be-encoded data based on a forward error correction encoding scheme includes the to-be-encoded data and the check sequence of the to-be-encoded data.

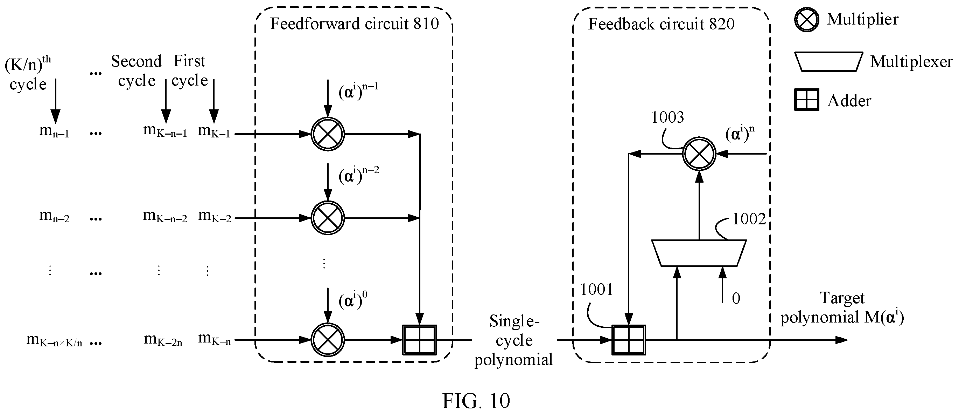

With reference to FIG. 9, FIG. 10 is a diagram of structures of a feedforward circuit and a feedback circuit according to an embodiment of this application.

As shown in FIG. 10, in a first cycle, the feedback circuit 820 receives a single-cycle polynomial $B_{1a}$ that is output by the feedforward circuit 810 and that indicates n symbols input in the first cycle. The feedback circuit 820 inputs 0 to a multiplier 1003 by using a multiplexer 1002. Then, the multiplier 1003 multiplies the coefficient $(\alpha^i)^n$ by 0, and outputs a multiplication result. In this case, the result is 0. An adder 1001 performs an addition operation on the result 0 output by the multiplier 1003 and the single-cycle polynomial $B_{1a}$ output by the feedforward circuit 810, to obtain a polynomial, denoted as $B_{1b}$, of a symbol that is of the to-be-encoded data and that is input to the feedforward circuit 810 in a previous cycle.

In a second cycle, the feedback circuit 820 receives the single-cycle polynomial $B_{2a}$ that is output by the feedforward circuit 810 and that indicates n symbols input in the second cycle. The feedback circuit 820 inputs, to the multiplier 1003 by using the multiplexer 1002, the polynomial $B_{1b}$ obtained through calculation by the feedback circuit 820 in the first cycle. It should be understood that the polynomial $B_{1b}$ obtained through calculation by the feedback circuit 820 in the first cycle is a calculation result obtained through calculation by the adder 1001 of the feedback circuit 820 in the first cycle. Then, the multiplier 1003 multiplies $B_{1b}$ by the coefficient $(\alpha^i)^u$, and outputs a multiplication result. In this case, the result is $B_{1b} \times (\alpha^i)^n$. The adder 1001 performs an addition operation on the result $B_{1b} \times (\alpha^i)^n$ output by the multiplier 1003 and the single-cycle polynomial $B_{2a}$ obtained through calculation by the feedforward circuit 810 for the n symbols input in the second cycle, to obtain a polynomial $B_{1b} \times (\alpha^i)^n + B_{2a}$ of the symbols that are of the to-be-encoded data and that are input to the feedforward circuit 810 in the first two cycles, where the polynomial is denoted as $B_{2b}$.

Similarly, in a $(K/n)^{th}$ cycle, the feedback circuit 820 receives a single-cycle polynomial $B_{(K/n)a}$ that is output by the feedforward circuit 810 and that indicates n symbols input in the $(K/n)^{th}$ cycle. The feedback circuit 820 inputs, to the multiplier 1003 by using the multiplexer 1002, a polynomial $B_{((K/n)-1)b}$ obtained through calculation by the feedback circuit 820 in a $[(K/n)-1]^{th}$ cycle. It should be understood that the polynomial $B_{((K/n)-1)b}$ obtained through calculation by the feedback circuit 820 in the $[(K/n)-1]^{th}$ cycle is a calculation result output by the adder 1001 of the feedback circuit 820 in the $[(K/n)-1]^{th}$ cycle. The multiplier 1003 multiplies $B_{((K/n)-1)b}$ by the coefficient $(\alpha^i)^u$, and outputs a multiplication result. In this case, the result is $B_{((K/n)-1)b} \times (\alpha^i)^n$. The adder 1001 performs an addition operation on the result $B_{((K/n)-i)b} \times (\alpha^i)^n$ output by the multiplier 1003 and the single-cycle polynomial $B_{(K/n)a}$ obtained through calculation by the feedforward circuit 810 for the n symbols input in the $(K/n)^{th}$ cycle, to obtain a polynomial $B_{((K/n)-1)b} \times (\alpha^i)^n + B_{(K/n)a}$ of K symbols that are of the to-be-encoded data and that are input to the feedforward circuit 810 in K/n cycles, where the polynomial is denoted as $B_{(K/n)b}$. In this case, $B_{(K/n)b}$ is the target polynomial, and the feedback circuit 820 outputs the target polynomial.

The feedforward circuit 810 and the feedback circuit 820 in the encoder 80 form a polynomial evaluation circuit in the encoder 80.

It should be understood that one polynomial evaluation circuit includes one feedforward circuit 810 and one feedback circuit 820, and the feedforward circuit 810 and the feedback circuit 820 in a same polynomial evaluation circuit perform operations in a same finite field, and use a same root of a generator polynomial when performing the operations in the finite field. Therefore, one target polynomial of the to-be-encoded data input to the encoder 80 in parallel can be obtained through calculation in the finite field by using one polynomial evaluation circuit.

To obtain $\Phi_{N,K}$ through calculation, in some embodiments, when a value of (N-K) is 1, the encoder 80 includes one polynomial evaluation circuit. In addition, a root of a generator polynomial used by a feedforward circuit and a feedback circuit in the polynomial evaluation circuit when performing operations in a finite field is $\alpha^0$.

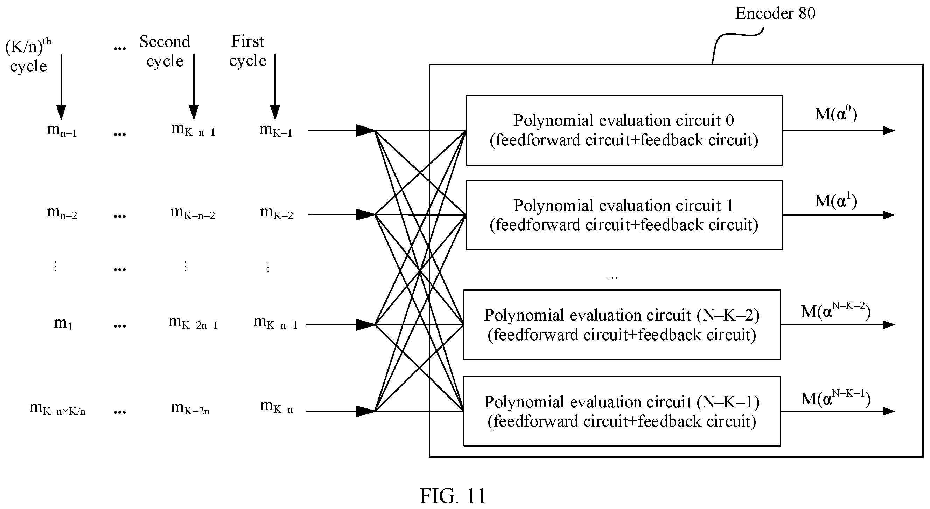

In some other embodiments, when the value of (N-K) is greater than 1, the encoder 80 includes (N-K) polynomial evaluation circuits. In this way, the (N-K) polynomial evaluation circuits are configured to perform calculation in the finite field by using a feedforward circuit and a feedback circuit in each of the (N-K) polynomial evaluation circuits, to obtain (N-K) target polynomials indicating the to-be-encoded data. FIG. 11 is a diagram of another structure of an encoder according to an embodiment of this application.

As shown in FIG. 11, the encoder 80 includes (N-K) polynomial evaluation circuits: a polynomial evaluation circuit 0, a polynomial evaluation circuit 1, ..., a polynomial evaluation circuit (N-K-2), and a polynomial evaluation circuit (N-K-1). A root of a generator polynomial used when a feedforward circuit and a feedback circuit in the polynomial evaluation circuit 0 perform operations in a finite field is $\alpha^0$; a root of a generator polynomial used when a feedforward circuit and a feedback circuit in the polynomial evaluation circuit 1 perform operations in a finite field is $\alpha^1$; ...; a root of a generator polynomial used when a feedforward circuit and a feedback circuit in the polynomial evaluation circuit (N-K-2) perform operations in a finite field is $\alpha^{N-K-2}$; and a root of a generator polynomial used when a feedforward circuit and a feedback circuit in the polynomial evaluation circuit (N-K-1) perform operations in a finite field is $\alpha^{N-K-1}$. In this way, to-be-encoded data received by the encoder 80 in K/n cycles may be separately input to each of the (N-K) polynomial evaluation circuits, to output a corresponding target polynomial obtained through calculation.

For example, the to-be-encoded data received by the encoder 80 in the K/n cycles is sequentially input to the polynomial evaluation circuit 0, so that the polynomial evaluation circuit 0 obtains, through calculation, a target polynomial $M(\alpha^0)$ when the root of the generator polynomial is $\alpha^0$ based on the to-be-encoded data received in the K/n cycles.

Similarly, the to-be-encoded data received by the encoder 80 in the K/n cycles is sequentially input to the polynomial evaluation circuit 1, so that the polynomial evaluation circuit 1 obtains, through calculation, a target polynomial $M(\alpha^1)$ when the root of the generator polynomial is $\alpha^1$ based on the to-be-encoded data received in the K/n cycles.

Similarly, the to-be-encoded data received by the encoder 80 in the K/n cycles is sequentially input to the polynomial evaluation circuit (N-K-2), so that the polynomial evaluation circuit (N-K-2) obtains, through calculation, a target polynomial $M(\alpha^{N-K-2})$ when the root of the generator polynomial is $\alpha^{N-K-2}$ based on the to-be-encoded data received in the K/n cycles.

Similarly, the to-be-encoded data received by the encoder 80 in the K/n cycles is sequentially input to the polynomial evaluation circuit (N-K-1) so that the polynomial evaluation circuit (N-K-1) obtains, through calculation, a target polynomial $M(\alpha^{N-K-1})$ when the root of the generator polynomial is $\alpha^{N-K-1}$ based on the to-be-encoded data received in the K/n cycles.

For detailed descriptions of how the polynomial evaluation circuit obtains, through calculation based on the to-be-encoded data received in the K/n cycles, the target polynomial $M(\alpha^i)$ when the root of the generator polynomial is $\alpha^i$, refer to the foregoing descriptions. Details are not described again.

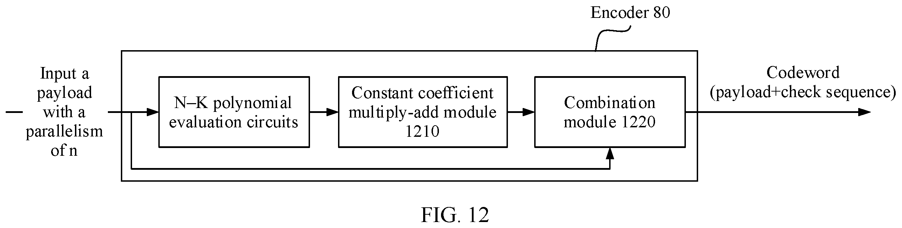

Further, after (N-K) target polynomials are obtained through calculation by using the (N-K) polynomial evaluation circuits, to obtain a check sequence of the to-be-encoded data through calculation based on the (N-K) target polynomials, refer to FIG. 12. FIG. 12 is a diagram of another structure of an encoder according to an embodiment of this application. As shown in FIG. 12, the encoder 80 further includes a constant coefficient multiply-add module 1210 and a combination module 1220.

The constant coefficient multiply-add module 1210 is configured to perform calculation based on a constant coefficient matrix and a target polynomial indicating to-be-encoded data, to obtain a check sequence of the to-be-encoded data. Specifically, the constant coefficient multiply-add module 1210 is configured to perform calculation based on the constant coefficient matrix and (N-K) target polynomials indicating the to-be-encoded data, to obtain the check sequence of the to-be-encoded data.

Herein, the constant coefficient matrix is the matrix $\Theta_{N,K}$ in the foregoing formula (13), and is denoted as a first constant coefficient matrix, and the (N-K) target polynomials indicating the to-be-encoded data are $\Phi_{N,K}$. Therefore, the constant coefficient multiply-add module 1210 may perform calculation based on $\Theta_{N,K}$, $\Phi_{N,K}$, and the foregoing mathematical constraint relationship $\Omega_{N,K} = \Theta_{N,K} \times \Phi_{N,K}$, to obtain $\Omega_{N,K}$, where $\Omega_{N,K}$ is the check sequence of the to-be-encoded data.

Specifically, as shown in FIG. 12, when the foregoing (N-K) polynomial evaluation circuits performs calculation on the to-be-encoded data input to the encoder 80 with a parallelism of n, and (N-K) target polynomials [including $M(\alpha^0)$, $M(\alpha^1)$, ..., $M(\alpha^{N-K-2})$, and $M(\alpha^{N-K-1})$] are output, the constant coefficient multiply-add module 1210 receives the (N-K) target polynomials, and performs calculation based on the first constant coefficient matrix and the (N-K) target polynomials, to obtain the check sequence of the to-be-encoded data.

For RS (N, K), the first coefficient matrix $\Theta_{N,K}$ is an (N-K)×(N-K) matrix. Therefore, the first constant coefficient matrix is preset in the encoder for implementing RS (N, K) encoding. Each coefficient of the first constant coefficient matrix is predetermined according to the formula (13). Because $\alpha$ is a root of a primitive polynomial in a finite field, during determining of each coefficient of the first constant coefficient matrix, the root $\alpha$ may be solved based on the primitive polynomial in the finite field, and then each coefficient of the first constant coefficient matrix is determined based on $\alpha$, a constant N, a constant K, and the formula (13). A finite field $GF(2^{10})$ is used as an example. A primitive polynomial in the finite field is $x^{10}+x^3+1$, so that a root $\alpha$ of the primitive polynomial can be solved based on the primitive polynomial. Further, each coefficient of the first constant coefficient matrix is determined based on the solved $\alpha$, the constant N, the constant K, and the formula (13).

Further, according to a matrix operation principle, the constant coefficient multiply-add module 1210 may use a plurality of submodules to obtain $\Omega_{N,K}$ through calculation based on the foregoing mathematical constraint relationship $\Omega_{N,K} = \Theta_{N,K} \times \Phi_{N,K}$. In other words, the constant coefficient multiply-add module 1210 includes (N-K) submodules, and each submodule is configured to calculate a corresponding check value based on a coefficient corresponding to the submodule and the (N-K) target polynomials (namely, $\Phi_{N,K}$) that indicate the to-be-encoded data. The (N-K) submodules obtain corresponding (N-K) check values, and the (N-K) check values form the check sequence of the to-be-encoded data.

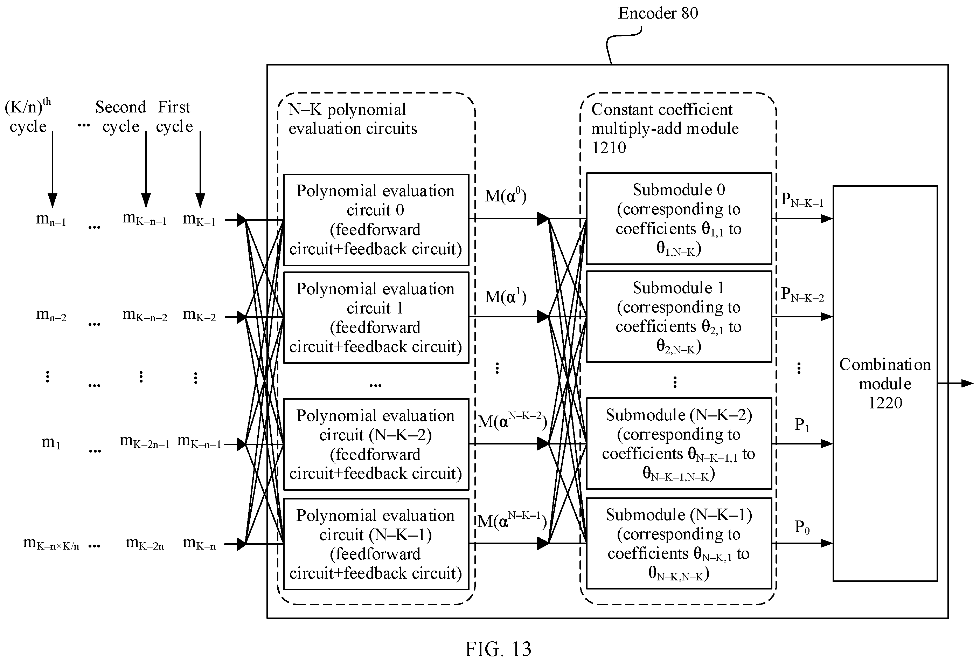

With reference to FIG. 11 and FIG. 12, FIG. 13 is a diagram of still another structure of an encoder according to an embodiment of this application. As shown in FIG. 13, the constant coefficient multiply-add module 1210 includes (N-K) submodules: a submodule 0, a submodule 1, ..., a submodule (N-K-2), and a submodule (N-K-1). Coefficients corresponding to the submodule 0 are coefficients in a row 1 of the matrix $\Theta_{N,K}$ shown in the formula (13), that is, $\theta_{1,1}$ to $\theta_{1,N-K}$; coefficients corresponding to the submodule 1 are coefficients in a row 2 of the matrix $\Theta_{N,K}$ shown in the formula (13), that is, $\theta_{2,1}$ to $\theta_{2,N-K}$; ...; coefficients corresponding to the submodule (N-K-2) are coefficients in a row (N-K-1) of the matrix $\Theta_{N,K}$ shown in the formula (13), that is, $\theta_{N-K-1,1}$ to $\theta_{N-K-1,N-K}$; and coefficients corresponding to the submodule (N-K-1) are coefficients in a row (N-K) of the matrix $\Theta_{N,K}$ shown in the formula (13), that is, $\theta_{N-K,1}$ to $\theta_{N-K,N}$-K.

In this way, after the foregoing (N-K) polynomial evaluation circuits performs calculation on the to-be-encoded data input to the encoder 80 with the parallelism of n in the K/n cycles, and the (N-K) target polynomials [including $M(\alpha^0)$, $M(\alpha^1)$, ..., $M(\alpha^{N-K-2})$, and $M(\alpha^{N-K-1})$] are output, the encoder 80 sends the (N-K) target polynomials to each submodule in the constant coefficient multiply-add module 1210, so that each submodule calculates a corresponding check value p based on a coefficient corresponding to the submodule and the (N-K) target polynomials (namely, $\Phi_{N,K}$) that indicate the to-be-encoded data. Further, the (N-K) submodules obtain corresponding (N-K) check values p, and the (N-K) check values p form the check sequence of the to-be-encoded data.

For example, the encoder 80 sends the (N-K) target polynomials to the submodule 0 in the constant coefficient multiply-add module 1210, and the submodule 0 performs a multiply-add operation on the coefficients $\theta_{1,1}$ to $\theta_{1,N-K}$ and the (N-K) target polynomials, to obtain a check value $p_{N-K-1}$. The multiply-add operation is specifically an operation of $[\theta_{1,1} \times M(\alpha^0) + \theta_{1,2} \times M(\alpha^1) + ... + \theta_{1,N-K-1} \times M(\alpha^{N-K-2}) + \theta_{1,N-K} \times M(\alpha^{N-K-1})]$ based on the mathematical constraint relationship $\Omega_{N,K} = \Theta_{N,K} \times \Phi_{N,K}$, the formula (13), and the formula (14).

Similarly, the encoder 80 sends the (N-K) target polynomials to the submodule 1 in the constant coefficient multiply-add module 1210, and the submodule 1 performs a multiply-add operation on the coefficients $\theta_{2,1}$ to $\theta_{2,N-K}$ and the (N-K) target polynomials, to obtain a check value $p_{N-K-2}$.

Similarly, the encoder 80 sends the (N-K) target polynomials to the submodule (N-K-2) in the constant coefficient multiply-add module 1210, and the submodule (N-K-2) performs a multiply-add operation on the coefficients $\theta_{N-K-1,1}$ to $\theta_{N-K-1,N-K}$ and the N-K target polynomials, to obtain a check value $p_1$.

Similarly, the encoder 80 sends the (N-K) target polynomials to the submodule (N-K-1) in the constant coefficient multiply-add module 1210, and the submodule (N-K-1) performs a multiply-add operation on the coefficients $\theta_{N-K,1}$ to $\theta_{N-K,N-K}$ and the N-K target polynomials, to obtain a check value $p_0$.

The combination module 1220 is configured to combine the to-be-encoded data and the check sequence of the to-be-encoded data, to obtain a codeword obtained by encoding the to-be-encoded data based on a forward error correction encoding scheme.

Specifically, the combination module 1220 receives the check sequence, of the to-be-encoded data, obtained through calculation by the constant coefficient multiply-add module 1210, receives the to-be-encoded data, and combines the to-be-encoded data and the check sequence of the to-be-encoded data, to obtain the codeword obtained by encoding the to-be-encoded data based on the forward error correction encoding scheme. Then, the combination module 1220 outputs the codeword including a payload and the check sequence. The payload in the codeword is the to-be-encoded data, and the check sequence of the codeword is the check sequence, of the to-be-encoded data, output by the constant coefficient multiply-add module 1210.

In this way, based on the encoder described above in embodiments of this application, when the encoder performs forward error correction encoding on the to-be-encoded data input to the encoder in parallel, the feedback circuit in the encoder is decoupled from the parallelism at which the to-be-encoded data is input to the encoder. Therefore, in a large bandwidth scenario, when the to-be-encoded data is input, at the high parallelism, to the encoder provided in embodiments of this application, a technical problem in which a timing closure is not achieved does not occur. This is because the addition and multiplication operations that need to be completed by the feedback circuit in the encoder provided in embodiments of this application can be completed in one clock cycle.

However, the feedforward circuit in the encoder 80 is related to the parallelism at which the to-be-encoded data is input to the encoder 80. In this case, when the parallelism n at which the to-be-encoded data is input to the encoder 80 is greater than a threshold, the feedforward circuit in the encoder 80 cannot complete calculation of a single-cycle polynomial in one clock cycle (which is also referred to as one cycle or one cycle). A specific value of the threshold is not limited in embodiments of this application.

In this case, the feedforward circuit 810 in the foregoing encoder 80 further includes a register. The register is configured to control the feedforward circuit 810 to complete, in at least two clock cycles, calculation of a polynomial (namely, a single-cycle polynomial) that indicates n symbols input in a single cycle, that is, the register is configured to control the feedforward circuit 810 to complete calculation of a single-cycle polynomial in at least two clock cycles. It should be understood that inserting one register into the feedforward circuit 810 can prolong, for one clock cycle, time for the feedforward circuit 810 to complete calculation of a single-cycle polynomial. Inserting two registers into the feedforward circuit 810 can prolong, for two clock cycles, time for the feedforward circuit 810 to complete calculation of a single-cycle polynomial.

In a first possible implementation, when the feedforward circuit 810 can complete calculation of a single-cycle polynomial in at least two clock cycles, the feedforward circuit 810 includes at least one register for prolonging time and a plurality of subcircuits. An operation amount of each of the plurality of subcircuits can be executed and completed in one clock cycle, and a number of subcircuits in the feedforward circuit 810 is a number of registers, for prolonging time, in the feedforward circuit 810 plus 1. For example, when the feedforward circuit 810 includes one register for prolonging time, the feedforward circuit 810 includes two subcircuits. For another example, when the feedforward circuit 810 includes two registers for prolonging time, the feedforward circuit 810 includes three subcircuits. Therefore, the feedforward circuit 810 can complete calculation of a single-cycle polynomial in at least two clock cycles through pipeline operations of at least two subcircuits by using the at least one register for prolonging time in the feedforward circuit 810. In addition, a last subcircuit in the pipeline in the feedforward circuit 810 is connected to the feedback circuit 820, to output a single-cycle polynomial to the feedback circuit. It should be understood that a working principle of the subcircuit is the same as the working principle of the feedforward circuit 810 described above. Details are not described again.

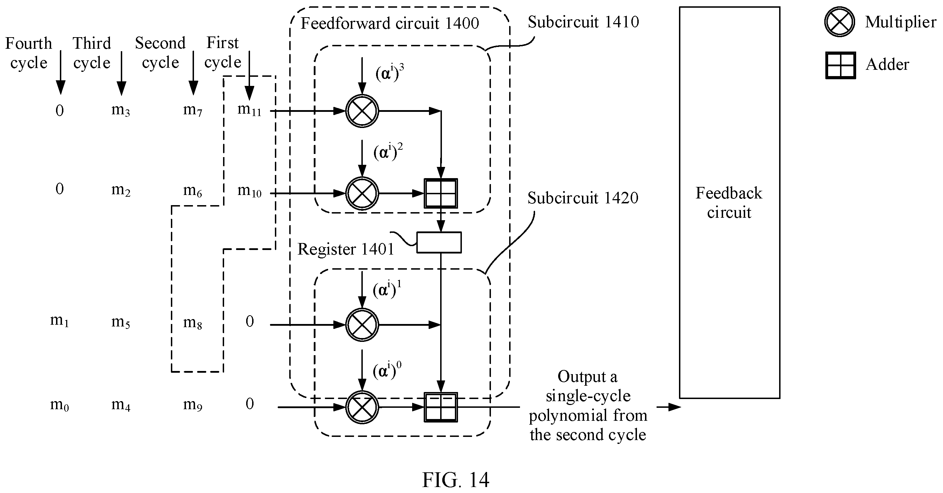

The following describes an implementation process of the first possible implementation by using an example in which the feedforward circuit 810 includes one register and the parallelism n at which the to-be-encoded data is input to the encoder 80 is 4. With reference to FIG. 10, FIG. 14 is another diagram of a feedforward circuit according to an embodiment of this application. A feedforward circuit 1400 is a feedforward circuit, with a value of n being 4, that is obtained by inserting one register 1401 into the feedforward circuit 810. The feedforward circuit 1400 includes a subcircuit 1410 and a subcircuit 1420, and the subcircuit 1420 is a last subcircuit in a pipeline in the feedforward circuit 1400. Therefore, the subcircuit 1420 is connected to a feedback circuit.

It is assumed that to-be-encoded data includes 12 symbols, and the 12 symbols are: $m_{11}$, $m_{10}$, $m_9$, $m_8$, $m_7$, $m_6$, $m_5$, $m_4$, $m_3$, $m_2$, $m_1$, and $m_0$. As shown in FIG. 14, the to-be-encoded data needs to be input to the feedforward circuit 1400 in the encoder in (K/n)+1 cycles (that is, (12/4) + 1 = 4 cycles).

In a first cycle, four symbols received by the feedforward circuit 1400 are $m_{11}$, $m_{10}$, 0, and 0. The subcircuit 1410 receives $m_{11}$ and $m_{10}$, to obtain a result 1a through calculation, and sends the result 1a to the subcircuit 1420. The subcircuit 1420 receives 0 and 0, and a result obtained through calculation is actually 0 (or the subcircuit 1420 does not receive any symbol in the first cycle). It should be noted that the subcircuit 1420, connected to the feedback circuit, in the feedforward circuit 1400 does not output a result in the first cycle.

In a second cycle, four symbols received by the feedforward circuit 1400 are $m_7$, $m_6$, $m_9$, and $m_8$. The subcircuit 1410 receives $m_7$ and $m_6$, to obtain a result 2a through calculation, and sends the result 2a to the subcircuit 1420. The subcircuit 1420 receives $m_9$ and $m_8$, to obtain a result 1b through calculation. Then, the subcircuit 1420 sums up the result 1b obtained through calculation in the second cycle and the result 1a sent by the subcircuit 1410 to the subcircuit 1420 in the first cycle, to obtain a result 1 in the second cycle, and outputs the result 1 to the feedback circuit. It can be learned that the result 1 is a single-cycle polynomial indicating $m_{11}$, $m_{10}$, $m_9$, and $m_8$, and the result 1 is a result obtained through calculation by the feedforward circuit 1400 in two clock cycles (the first cycle and the second cycle). In other words, in the second cycle, the subcircuit 1420 in the feedforward circuit 1400 outputs, to the feedback circuit, the single-cycle polynomial (namely, the result 1) indicating $m_{11}$, $m_{10}$, $m_9$, and $m_8$.

Similarly, in a third cycle, four symbols received by the feedforward circuit 1400 are $m_3$, $m_2$, $m_5$, and $m_4$. The subcircuit 1410 receives $m_3$ and $m_2$, to obtain a result 3a through calculation, and sends the result 3a to the subcircuit 1420. The subcircuit 1420 receives $m_5$ and $m_4$, to obtain a result 2b through calculation. Then, the subcircuit 1420 sums up the result 2b obtained through calculation in the third cycle and the result 2a sent by the subcircuit 1410 to the subcircuit 1420 in the second cycle, to obtain a result 2 in the third cycle, and outputs the result 2 to the feedback circuit. It can be learned that the result 2 is a single-cycle polynomial indicating $m_7$, $m_6$, $m_5$, and $m_4$, and the result 2 is a result obtained through calculation by the feedforward circuit 1400 in two clock cycles (the second cycle and the third cycle). In other words, in the third cycle, the subcircuit 1420 in the feedforward circuit 1400 outputs, to the feedback circuit, the single-cycle polynomial (namely, the result 2) indicating $m_7$, $m_6$, $m_5$, and $m_4$.

Similarly, in a fourth cycle, four symbols received by the feedforward circuit 1400 are 0, 0, $m_1$, and $m_0$. The subcircuit 1410 receives 0 and 0, to obtain, through calculation, a result that is actually 0, and sends 0 to the subcircuit 1420. The subcircuit 1420 receives $m_1$ and $m_0$, to obtain a result 3b through calculation. Then, the subcircuit 1420 sums up the result 3b obtained through calculation in the fourth cycle and the result 3a sent by the subcircuit 1410 to the subcircuit 1420 in the third cycle, to obtain a result 3 in the third cycle, and outputs the result 3 to the feedback circuit. It can be learned that the result 3 is a single-cycle polynomial indicating $m_3$, $m_2$, $m_1$, and $m_0$, and the result 3 is a result obtained through calculation by the feedforward circuit 1400 in two clock cycles (the third cycle and the fourth cycle). In other words, in the fourth cycle, the subcircuit 1420 in the feedforward circuit 1400 outputs, to the feedback circuit, the single-cycle polynomial (namely, the result 3) indicating $m_3$, $m_2$, $m_1$, and $m_0$.

In this case, the 12 symbols in the to-be-encoded data are all input to the feedforward circuit 1400 in four cycles, the single-cycle polynomial indicating $m_{11}$, $m_{10}$, $m_9$, and $m_8$ is output in the second cycle, the single-cycle polynomial indicating $m_7$, $m_6$, $m_5$, and $m_4$ is output in the third cycle, and the single-cycle polynomial indicating $m_3$, $m_2$, $m_1$, and $m_0$ is output in the fourth cycle. In this embodiment of this application, the manner of inputting the to-be-encoded data to the feedforward circuit 1400 shown in FIG. 14 is referred to as a half-cycle staggered input manner. In this manner, calculation of a polynomial indicating n symbols with a parallelism of n can be completed in two clock cycles (two cycles).

Based on the foregoing implementation, it can be ensured that the feedforward circuit 810 in the encoder 80 completes calculation of a single-cycle polynomial in at least two clock cycles. In other words, in a large bandwidth scenario, even if an input to the encoder 80 is at high parallelism, the encoder 80 provided in embodiments of this application can complete forward error correction encoding. In comparison with the current encoding circuit shown in FIG. 2, when a feedback loop cannot complete data calculation in one clock cycle, due to a constraint of the feedback loop in time domain, the encoding circuit shown in FIG. 2 cannot insert a register into the feedback loop to prolong operation time of the feedback loop. Consequently, in a scenario of large bandwidth and an input at high parallelism, the current technology has a technical defect in which a timing closure is not achieved in time domain. However, the encoder provided in embodiments of this application does not have this technical defect.

In some other embodiments, an RS $(N+\Delta N, K)$ code pattern is described. RS $(N+\Delta N, K)$ indicates that a length of a codeword obtained through encoding is $N+\Delta N$ and a payload length is K. Correspondingly, a length of a check sequence of the codeword obtained through encoding is $N+\Delta N-K$. N, $\Delta N$, and K are all integers, and N is greater than K.

Based on the foregoing descriptions of the RS $(N, K)$ code pattern, when RS $(N+\Delta N, K)$ encoding is implemented, $\Theta_{N+\Delta N,K}$ satisfies a formula (18), so that $\Phi_{N+\Delta N,K}$ satisfies a formula (19), and $\Omega_{N+\Delta N,K}$ satisfies a formula (20). $\Theta_{N+\Delta N,K}$ is obtained by replacing N in $\Theta_{N,K}$ shown in the formula (13) with $(N+\Delta N)$, $\Phi_{N+\Delta N,K}$ is obtained by replacing N in $\Phi_{N,K}$ shown in the formula (14) with $(N+\Delta N)$, and $\Omega_{N+\Delta N,K}$ is obtained by replacing N in $\Omega_{N,K}$ shown in the formula (15) with $(N+\Delta N)$.

$$\text{Formula (18)} \ \Theta_{N+\Delta N,K}=$$

$$\begin{bmatrix}
(\alpha^0)^{-1} & (\alpha^0)^{-2} & \cdots & (\alpha^0)^{K-N+1} & (\alpha^0)^{K-N} & (\alpha^0)^{K-N-1} & \cdots & (\alpha^0)^{K-N-\Delta N} \\
(\alpha^1)^{-1} & (\alpha^1)^{-2} & \cdots & (\alpha^1)^{K-N+1} & (\alpha^1)^{K-N} & (\alpha^1)^{K-N-1} & \cdots & (\alpha^1)^{K-N-\Delta N} \\
(\alpha^2)^{-1} & (\alpha^2)^{-2} & \cdots & (\alpha^2)^{K-N+1} & (\alpha^2)^{K-N} & (\alpha^2)^{K-N-1} & \cdots & (\alpha^2)^{K-N-\Delta N} \\
\vdots & \vdots & \ddots & \vdots & \vdots & \vdots & \ddots & \vdots \\
(\alpha^{N-K-1})^{-1} & (\alpha^{N-K-1})^{-2} & \cdots & (\alpha^{N-K-1})^{K-N+1} & (\alpha^{N-K-1})^{K-N} & (\alpha^{N-K-1})^{K-N-1} & \cdots & (\alpha^{N-K-1})^{K-N-\Delta N} \\
(\alpha^{N-K})^{-1} & (\alpha^{N-K})^{-2} & \cdots & (\alpha^{N-K})^{K-N+1} & (\alpha^{N-K})^{K-N} & (\alpha^{N-K})^{K-N-1} & \cdots & (\alpha^{N-K})^{K-N-\Delta N} \\
\vdots & \vdots & \ddots & \vdots & \vdots & \vdots & \ddots & \vdots \\
(\alpha^{N+\Delta N-K-1})^{-1} & (\alpha^{N+\Delta N-K-1})^{-2} & \cdots & (\alpha^{N+\Delta N-K-1})^{K-N+1} & (\alpha^{N+\Delta N-K-1})^{K-N} & (\alpha^{N+\Delta N-K-1})^{K-N-1} & \cdots & (\alpha^{N+\Delta N-K-1})^{K-N-\Delta N}
\end{bmatrix}^{-1}$$

$$=\begin{bmatrix}
\theta_{1,1} & \theta_{1,2} & \cdots & \theta_{1,N-K} & \theta_{1,N+1-K} & \cdots & \theta_{1,N+\Delta N-K} \\
\theta_{2,1} & \theta_{2,2} & \cdots & \theta_{2,N-K} & \theta_{2,N+1-K} & \cdots & \theta_{2,N+\Delta N-K} \\
\vdots & \vdots & \ddots & \vdots & \vdots & \ddots & \vdots \\
\theta_{N-K,1} & \theta_{N-K,2} & \cdots & \theta_{N-K,N-K} & \theta_{N-K,N+1-K} & \cdots & \theta_{N-K,N+\Delta N-K} \\
\theta_{N+1-K,1} & \theta_{N+1-K,2} & \cdots & \theta_{N+1-K,N-K} & \theta_{N+1-K,N+1-K} & \cdots & \theta_{N+1-K,N+\Delta N-K} \\
\vdots & \vdots & \ddots & \vdots & \vdots & \ddots & \vdots \\
\theta_{N+\Delta N-K,1} & \theta_{N+\Delta N-K,2} & \cdots & \theta_{N+\Delta N-K,N-K} & \theta_{N+\Delta N-K,N+1-K} & \cdots & \theta_{N+\Delta N-K,N+\Delta N-K}
\end{bmatrix}$$

$$\text{Formula (19)} \quad \Phi_{N+\Delta N,K} = \begin{bmatrix} M(\alpha^0) \\ M(\alpha^1) \\ M(\alpha^2) \\ \vdots \\ M(\alpha^{N-K-1}) \\ M(\alpha^{N-K}) \\ \vdots \\ M(\alpha^{N+\Delta N-K-1}) \end{bmatrix}$$

$$\text{Formula (20)} \quad \Omega_{N+\Delta N,K} = \begin{bmatrix} p_{N+\Delta N-K-1} \\ \vdots \\ p_{N-K} \\ p_{N-K-1} \\ p_{N-K-2} \\ \vdots \\ p_1 \\ p_0 \end{bmatrix}$$

It can be learned that, in the RS (N+$\Delta$N, K) code pattern, $\Theta_{N+\Delta N,K}$ indicates a set of $(N+\Delta N-K)^2$ constant coefficients, $\Phi_{N+\Delta N,K}$ indicates a set of polynomials of a payload in an RS codeword, and $\Omega_{N+\Delta N,K}$ indicates the check sequence of the RS codeword. In addition, $\Theta_{N+\Delta N,K}$, $\Phi_{N+\Delta N,K}$, and $\Omega_{N+\Delta N,K}$ meet a mathematical constraint relationship: $\Omega_{N+\Delta N,K} = \Theta_{N+\Delta N,K} \times \Phi_{N+\Delta N,K}$.

In this way, for the RS (N+$\Delta$N, K) code pattern, that is, when a length of a codeword obtained by encoding to-be-encoded data based on a forward error correction encoding scheme is N+$\Delta$N and a payload length is K, an encoder for implementing RS (N+$\Delta$N, K) encoding includes (N+$\Delta$N-K) polynomial evaluation circuits, and each of the (N+$\Delta$N-K) polynomial evaluation circuits includes the feedforward circuit and the feedback circuit described above. Therefore, the (N+$\Delta$N-K) polynomial evaluation circuits are configured to perform calculation in a finite field by using the feedforward circuit and the feedback circuit in each polynomial evaluation circuit, to obtain (N+$\Delta$N-K) target polynomials indicating the to-be-encoded data, that is, obtain $\Phi_{N+\Delta N,K}$. For detailed descriptions of structures and working principles of the feedforward circuit, the feedback circuit, and the polynomial evaluation circuit, refer to the foregoing descriptions. Details are not described again.

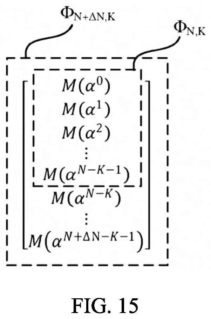

It can be learned from the formula (14) and the formula (19) that $\Phi_{N+\Delta N,K}$ includes $\Phi_{N,K}$. For details, refer to FIG. 15. FIG. 15 is a diagram of a relationship between sets of polynomials indicating payloads in a case in which codeword lengths are different according to an embodiment of this application. As shown in FIG. 15, $\Phi_{N,K}$ is a part of $\Phi_{N+\Delta N,K}$, that is, $\Phi_{N+\Delta N,K}$ includes $\Phi_{N,K}$.

Given that $\Phi_{N+\Delta N,K}$ includes $\Phi_{N,K}$, the (N+$\Delta$N-K) polynomial evaluation circuits in the encoder for implementing RS (N+$\Delta$N, K) encoding include the (N-K) polynomial evaluation circuits in the encoder for implementing RS (N, K) encoding. In other words, the (N+$\Delta$N-K) polynomial evaluation circuits in the encoder for implementing RS (N+$\Delta$N, K) encoding can reuse the (N-K) polynomial evaluation circuits in the encoder for implementing RS (N, K) encoding.

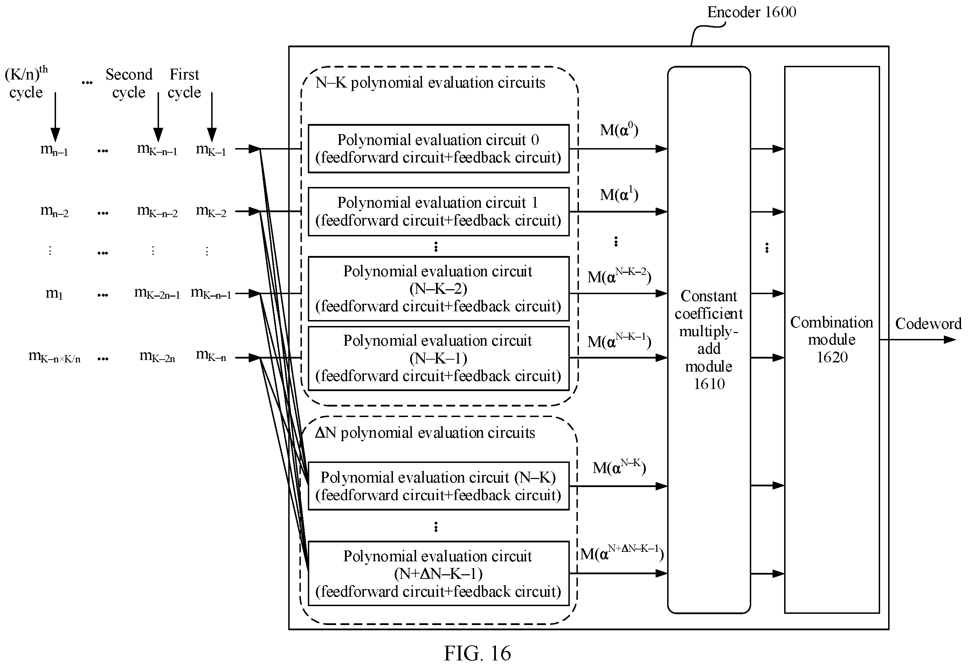

FIG. 16 is a diagram of a structure of an encoder 1600 according to an embodiment of this application. The encoder 1600 is the encoder for implementing RS (N+$\Delta$N, K) encoding. As shown in FIG. 16, the encoder 1600 includes the (N-K) polynomial evaluation circuits in the foregoing encoder 80, and further includes $\Delta$N polynomial evaluation circuits: a polynomial evaluation circuit (N-K), ..., and a polynomial evaluation circuit (N+$\Delta$N-K-1). The encoder 1600 further includes a constant coefficient multiply-add module 1610 and a combination module 1620. For detailed descriptions of the constant coefficient multiply-add module 1610 and the combination module 1620, refer to the foregoing descriptions. Details are not described herein again.

The polynomial evaluation circuit (N-K) is configured to obtain, through calculation based on to-be-encoded data received in K/n cycles, a target polynomial $M(\alpha^{N-K})$ when a root of a generator polynomial is $\alpha^{N-K}$. The polynomial evaluation circuit (N+$\Delta$N-K-1) is configured to obtain, through calculation based on the to-be-encoded data received in the K/n cycles, a target polynomial $M(\alpha^{N+\Delta N-K-1})$ when the root of the generator polynomial is $\alpha^{N+\Delta N-K-1}$.

It can be learned that the (N+$\Delta$N-K) polynomial evaluation circuits in the encoder 1600 for implementing encoding based on the RS (N+$\Delta$N, K) code pattern include the (N-K) polynomial evaluation circuits in the encoder 80 for implementing encoding based on the RS (N, K) code pattern. Because an error correction capability of the RS (N+$\Delta$N, K) code pattern is (N+$\Delta$N-K)/2, and an error correction capability of the RS (N, K) code pattern is (N-K)/2, the error correction capability of the RS (N+$\Delta$N, K) code pattern is higher than that of the RS (N, K) code pattern. Therefore, the encoder provided in embodiments of this application can implement that, in a process of encoding RS code patterns with different error correction capabilities, a polynomial evaluation circuit in an encoder for an RS code pattern with a high error correction capability can reuse a polynomial evaluation circuit in an encoder for an RS code pattern with a low error correction capability. In other words, based on the design of the encoder provided in embodiments of this application, the encoder for the RS code pattern with a high error correction capability and the encoder for the RS code pattern with a low error correction capability can share a common polynomial evaluation circuit (that is, reused by the two encoders), to greatly reduce a circuit area and power consumption of the circuit during actual circuit implementation.

In addition, for the RS $(N+\Delta N, K)$ code pattern, that is, when the length of the codeword obtained by encoding the to-be-encoded data based on the forward error correction encoding scheme is $N+\Delta N$ and the payload length is K, a constant coefficient matrix preset in the constant coefficient multiply-add module in the encoder for implementing RS $(N+\Delta N, K)$ encoding is the foregoing matrix $\Theta_{N+\Delta N,K}$, where the matrix is denoted as a second constant coefficient matrix. It can be learned from the formula (18) that the second constant coefficient matrix $\Theta_{N+\Delta N,K}$ is an $(N+\Delta N-K)\times(N+\Delta N-K)$ matrix.

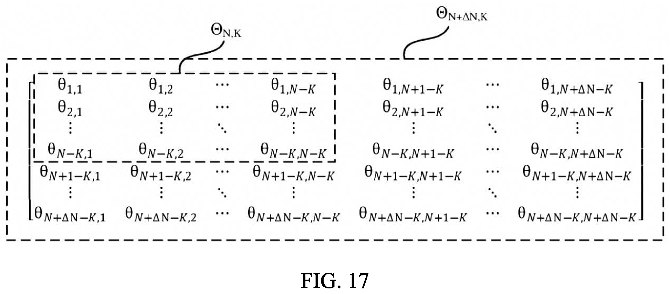

It can be learned from the formula (13) and the formula (18) that $\Theta_{N+\Delta N,K}$ includes $\Theta_{N,K}$. For details, refer to FIG. 17. FIG. 17 is a diagram of a relationship between constant coefficient sets in a case in which codeword lengths are different according to an embodiment of this application. As shown in FIG. 17, $\Theta_{N,K}$ is a part of $\Theta_{N+\Delta N,K}$, that is, $\Theta_{N+\Delta N,K}$ includes $\Theta_{N,K}$.

Given that $\Theta_{N+\Delta N,K}$ includes $\Theta_{N,K}$, the second constant coefficient matrix $\Theta_{N+\Delta N,K}$ preset in the constant coefficient multiply-add module in the encoder for implementing RS $(N+\Delta N, K)$ encoding includes the first constant coefficient matrix $\Theta_{N,K}$ preset in the constant coefficient multiply-add module in the encoder for implementing RS $(N, K)$ encoding. In other words, the second constant coefficient matrix $\Theta_{N+\Delta N,K}$ preset in the constant coefficient multiply-add module in the encoder for implementing RS $(N+\Delta N, K)$ encoding may reuse the first constant coefficient matrix $\Theta_{N,K}$ preset in the constant coefficient multiply-add module in the encoder for implementing RS $(N, K)$ encoding.

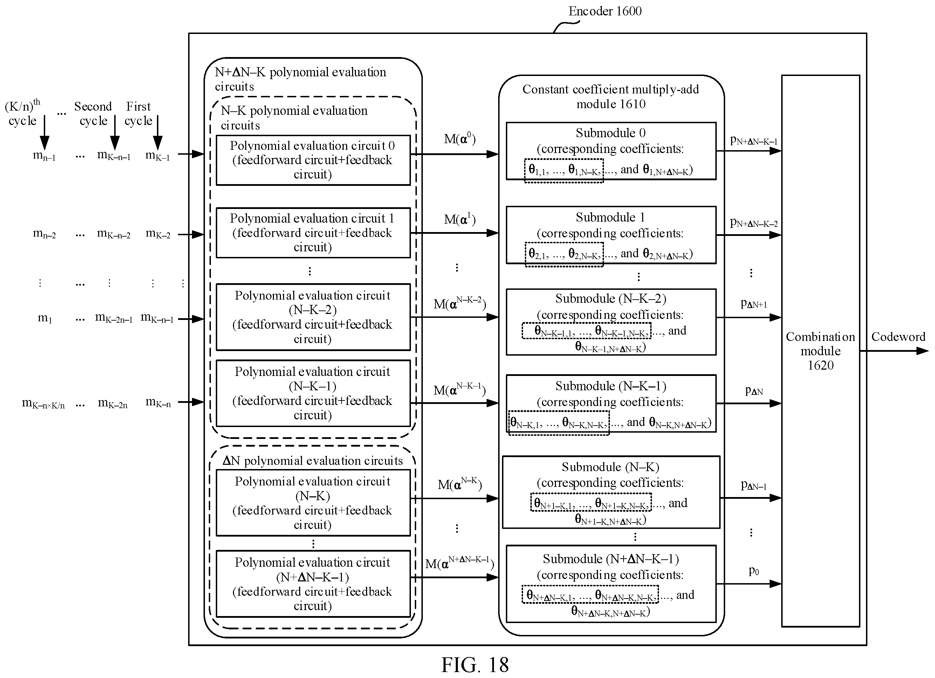

With reference to FIG. 16, FIG. 18 is a diagram of another structure of an encoder 1600 according to an embodiment of this application. The encoder 1600 is the encoder for implementing RS $(N+\Delta N, K)$ encoding. As shown in FIG. 18, the constant coefficient multiply-add module 1610 in the encoder 1600 includes $(N+\Delta N-K)$ submodules: a submodule 0, a submodule 1, ..., a submodule (N-K-2), a submodule (N-K-1), a submodule (N-K), ..., and a submodule $(N+\Delta N-K-1)$. Coefficients corresponding to the submodule 0 are coefficients in a row 1 of the matrix $\Theta_{N+\Delta N,K}$ shown in the formula (18), that is, $\theta_{1,1}, ..., \theta_{1,N-K}, ...,$ and $\theta_{1,N+\Delta N-K}$; coefficients corresponding to the submodule 1 are coefficients in a row 2 of the matrix $\Theta_{N+\Delta N,K}$ shown in the formula (18), that is, $\theta_{2,1}, ..., \theta_{2,N-K}, ...,$ and $\theta_{2,N+\Delta N-K}$; ...; coefficients corresponding to the submodule (N-K-2) are coefficients in a row (N-K-1) of the matrix $\Theta_{N+\Delta N,K}$ shown in the formula (18), that is, $\theta_{N-K-1,1}, ..., \theta_{N-K-1,N-K}, ...,$ and $\theta_{N-K-1,N+\Delta N-K}$; and coefficients corresponding to the submodule (N-K-1) are coefficients in a row (N-K) of the matrix $\Theta_{N+\Delta N,K}$ shown in the formula (18), that is, $\theta_{N-K,1}, ..., \theta_{N-K,N-K}, ...,$ and $\theta_{N-K,N+\Delta N-K}$. Coefficients corresponding to the submodule (N-K) are coefficients in a row (N+1-K) of the matrix $\Theta_{N+\Delta N,K}$ shown in the formula (18), that is, $\theta_{N+1-K,1}, ..., \theta_{N+1-K,N-K}, ...,$ and $\theta_{N+1-K,N+\Delta N-K}$; ...; and coefficients corresponding to the submodule $(N+\Delta N-K-1)$ are coefficients in a row $(N+\Delta N-K)$ of the matrix $\Theta_{N+\Delta N,K}$ shown in the formula (18), that is, $\theta_{N+\Delta N-K,1}, ..., \theta_{N+\Delta N-K,N-K}, ...,$ and $\theta_{N+\Delta N-K,N+\Delta N-K}$.

In this way, after the foregoing $(N+\Delta N-K)$ polynomial evaluation circuits performs calculation on the to-be-encoded data input to the encoder 1600 with the parallelism of n in the K/n cycles, and the $(N+\Delta N-K)$ target polynomials [including $M(\alpha^0)$, $M(\alpha^1)$, ..., $M(\alpha^{N-K-2})$, $M(\alpha^{N-K-1})$, $M(\alpha^{N-K})$, ..., and $M(\alpha^{N+\Delta N-K-1})$] are output, the encoder 1600 sends the $(N+\Delta N-K)$ target polynomials to each submodule in the constant coefficient multiply-add module 1610, so that each submodule calculates a corresponding check value p based on a coefficient corresponding to the submodule and the $(N+\Delta N-K)$ target polynomials (namely, $\Theta_{N+\Delta N,K}$) that indicate the to-be-encoded data. Further, the $(N+\Delta N-K)$ submodules obtain corresponding $(N+\Delta N-K)$ check values p, and the $(N+\Delta N-K)$ check values p form the check sequence of the to-be-encoded data.

For example, the encoder 1600 sends the $(N+\Delta N-K)$ target polynomials to the submodule 0 in the constant coefficient multiply-add module 1610, and the submodule 0 performs a multiply-add operation on the coefficients $(\theta_{1,1}, ..., \theta_{1,N-K}, ...,$ and $\theta_{1,N+\Delta N-K})$ and the $(N+\Delta N-K)$ target polynomials, to obtain a check value $p_{N+\Delta N-K-1}$. The multiply-add operation is specifically an operation of $[\theta_{1,1}\times M(\alpha^0)+\theta_{1,2}\times M(\alpha^1)+...+\theta_{1,N-K-1}\times M(\alpha^{N-K-2})+\theta_{1,N-K}\times M(\alpha^{N-K-1})+\theta_{1,N+1-K}\times M(\alpha^{N-K})+\theta_{1,N+\Delta N-K}\times M(\alpha^{N+\Delta N-K-1})]$ based on the mathematical constraint relationship $\Omega_{N+\Delta N,K} = \Theta_{N+\Delta N,K} \times \Phi_{N+\Delta N,K}$, the formula (18), and the formula (19).

Similarly, the encoder 1600 sends the $(N+\Delta N-K)$ target polynomials to the submodule 1 in the constant coefficient multiply-add module 1610, and the submodule 1 performs a multiply-add operation on the coefficients $(\theta_{2,1}, ..., \theta_{2,N-K}, ...,$ and $\theta_{2,N+\Delta N-K})$ and the $(N+\Delta N-K)$ target polynomials, to obtain a check value $p_{N+\Delta N-K-2}$.

Similarly, the encoder 1600 sends the $(N+\Delta N-K)$ target polynomials to the submodule (N-K-2) in the constant coefficient multiply-add module 1610, and the submodule (N-K-2) performs a multiply-add operation on the coefficients $(\theta_{N-K-1,1}, ..., \theta_{N-K-1,N-K}, ...,$ and $\theta_{N-K-1,N+\Delta N-K})$ and the $(N+\Delta N-K)$ target polynomials, to obtain a check value $p_{\Delta N+1}$.

Similarly, the encoder 1600 sends the $(N+\Delta N-K)$ target polynomials to the submodule (N-K-1) in the constant coefficient multiply-add module 1610, and the submodule (N-K-1) performs a multiply-add operation on the coefficients ($\theta_{N-K,1}$, ..., $\theta_{N-K,N-K}$, ..., and $\theta_{N-K,N+\Delta N-K}$) and the (N+$\Delta$N-K) target polynomials, to obtain a check value $p_{\Delta N}$.

Similarly, the encoder 1600 sends the (N+$\Delta$N-K) target polynomials to the submodule (N-K) in the constant coefficient multiply-add module 1610, and the submodule (N-K) performs a multiply-add operation on the coefficients ($\theta_{N+1-K,1}$, ..., $\theta_{N+1-K,N-K}$, ..., and $\theta_{N+1-K,N+\Delta N-K}$) and the (N+$\Delta$N-K) target polynomials, to obtain a check value $p_{\Delta N-1}$.

Similarly, the encoder 1600 sends the (N+$\Delta$N-K) target polynomials to the submodule (N+$\Delta$N-K-1) in the constant coefficient multiply-add module 1610, and the submodule (N+$\Delta$N-K-1) performs a multiply-add operation on the coefficients ($\theta_{N+\Delta N-K,1}$, ..., $\theta_{N+\Delta N-K,N-K}$, ..., and $\theta_{N+\Delta N-K,N+\Delta N-K}$) and the (N+$\Delta$N-K) target polynomials, to obtain a check value $p_0$.

It can be learned from the descriptions in FIG. 13 that the constant coefficient multiply-add module 1610 in the encoder for implementing the RS (N+$\Delta$N, K) code pattern includes a specific implementation circuit in the constant coefficient multiply-add module 1210 in the encoder for implementing the RS (N, K) code pattern. The submodule 0 in the constant coefficient multiply-add module 1610 is used as an example. The submodule 0 in the constant coefficient multiply-add module 1610 includes a specific implementation circuit in the submodule 0 in the constant coefficient multiply-add module 1210 shown in FIG. 13. The implementation circuit is a circuit configured to perform a multiply-add operation on the target polynomials and the coefficients ($\theta_{1,1}$ to $\theta_{1,N-K}$). The submodule (N-K-1) in the constant coefficient multiply-add module 1610 is used as another example. The submodule (N-K-1) in the constant coefficient multiply-add module 1610 includes a specific implementation circuit in the submodule (N-K-1) in the constant coefficient multiply-add module 1210 shown in FIG. 13. The implementation circuit is a circuit configured to perform a multiply-add operation on the target polynomials and the coefficients ($\theta_{N-K,1}$ to $\theta_{N-K,N-K}$).

In other words, the (N+$\Delta$N-K) submodules in the constant coefficient multiply-add module in the encoder 1600 include the (N-K) submodules in the constant coefficient multiply-add module in the encoder 80. Because the error correction capability [(N+$\Delta$N-K)/2] of the encoder 1600 for implementing encoding based on the RS (N+$\Delta$N, K) code pattern is higher than the error correction capability [(N-K)/2] of the encoder 80 for implementing encoding based on the RS (N, K) code pattern, the constant coefficient multiply-add module 1610 in the encoder 1600 with a high error correction capability can reuse the specific implementation circuit in the constant coefficient multiply-add module 1210 in the encoder 80 with a low error correction capability. In other words, the encoder provided in embodiments of this application can implement that, in a process of encoding RS code patterns with different error correction capabilities, a constant coefficient multiply-add module in an encoder for an RS code pattern with a high error correction capability can reuse a constant coefficient multiply-add module in an encoder for an RS code pattern with a low error correction capability. In other words, based on the design of the encoder provided in embodiments of this application, the encoder for the RS code pattern with a high error correction capability and the encoder for the RS code pattern with a low error correction capability can share an implementation circuit of a common constant coefficient multiply-add module (that is, reused by the two encoders), to greatly reduce a circuit area and power consumption of the circuit during actual circuit implementation.

In addition, with reference to FIG. 15 to FIG. 18, the encoder provided in embodiments of this application for implementing encoding based on the RS (N+$\Delta$N, K) code pattern with a high error correction capability can reuse the polynomial evaluation circuit and the circuit in the constant coefficient multiply-add module in the encoder for implementing encoding based on the RS (N, K) code pattern with a low error correction capability. In this way, the encoder for implementing encoding based on the RS (N+$\Delta$N, K) code pattern with a high error correction capability can implement encoding based on the RS (N, K) code pattern with a low error correction capability. In other words, the encoder in embodiments of this application can support encoding of at least one forward error correction code pattern, and each of the at least one forward error correction code pattern has a different error correction capability. It may also be understood as that the encoder provided in embodiments of this application is a hybrid encoder, for forward error correction encoding, that can support code patterns with a plurality of error correction capabilities.

For example, when the encoder provided in embodiments of this application is an encoder for implementing the RS (N+$\Delta$N, K) code pattern, the encoder supports encoding of at least one forward error correction code pattern. Each of the at least one forward error correction code pattern has a different error correction capability, and an error correction capability of a codeword obtained through encoding based on the at least one forward error correction code pattern is less than or equal to (N+$\Delta$N-K)/2. In other words, the error correction capability of the codeword obtained through encoding based on the at least one forward error correction code pattern is less than or equal to the error correction capability of the RS (N+$\Delta$N, K) code pattern.

It should be understood that $\Phi_{N,K}$ in $\Phi_{N+\Delta N,K}$ needs to be equal to 0, and $\Theta_{N+\Delta N,K}$ in the constant coefficient multiply-add module needs to be replaced with $\Theta_{N,K}$ (or a circuit module configured to perform a multiply-add operation on the target polynomials and the coefficient $\Theta_{N,K}$ in the constant coefficient multiply-add module constructed based on $\Theta_{N+\Delta N,K}$ is reused) when the encoder for the RS (N+$\Delta$N, K) code pattern implements encoding based on the RS (N, K) code pattern. Therefore, the encoder for the RS (N+$\Delta$N, K) code pattern can implement encoding based on the RS (N, K) code pattern. $\Phi_{\Delta N,K}$ includes [M($\alpha^{N-K}$), ..., and M($\alpha^{N+\Delta N-K-1}$)].

For example, when $\Phi_{\Delta N,K}$ needs to be equal to 0, the encoder may send, by using the multiplexer, a coefficient 0 to the multiplier in each of the ΔN polynomial evaluation circuits shown in FIG. 16, so that $\Phi_{\Delta N,K}=0$ can be implemented.

To better understand beneficial effect of embodiments of this application, the following further describes the encoder provided in embodiments of this application by using examples.

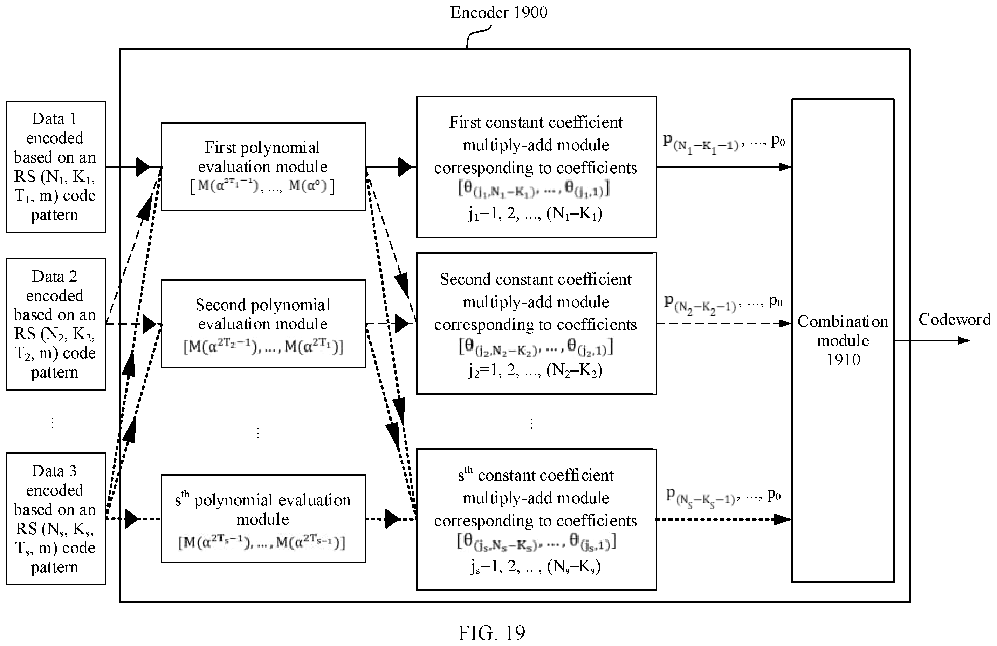

An encoder that can simultaneously support encoding based on an RS $(N_1, K_1, T_1, m)$ code pattern, an RS $(N_2, K_2, T_2, m)$ code pattern, ..., and an RS $(N_s, K_s, T_s, m)$ code pattern is used as an example. FIG. 19 is a diagram of a structure of an encoder supporting hybrid encoding based on a plurality of code patterns according to an embodiment of this application. N is a length of a codeword obtained through forward error correction encoding, K is a payload length in the codeword, m indicates a finite field for RS encoding calculation, T is an error correction capability, and T = (N - K)/2. Further, N - K = 2T. In addition, $T_1, T_2, ...,$ and $T_s$ are set to be monotonically increasing in sequence, that is, $T_1 < T_2 < ... < T_s$, where s is an integer.

As shown in FIG. 19, an encoder 1900 includes s polynomial evaluation modules: a first polynomial evaluation module, a second polynomial evaluation module, ..., and an $s^{th}$ polynomial evaluation module.

The first polynomial evaluation module includes $(N_1-K_1)$ polynomial evaluation circuits, and is configured to perform calculation based on received data, to obtain $(N_1-K_1)$ (namely, $2T_1$) target polynomials $[M(\alpha^{2T_1-1}), ..., M(\alpha^0)]$, that is, $[M(\alpha^{N_1-K_1-1}), ..., M(\alpha^0)]$. The second polynomial evaluation module includes $(2T_2-2T_1)$ polynomial evaluation circuits, and is configured to perform calculation based on the received data, to obtain $(2T_2-2T_1)$ target polynomials $[M(\alpha^{2T_2-1}), ..., M(\alpha^{2T_1})]$. In addition, the $s^{th}$ polynomial evaluation module includes $(2T_s-2T_{s-1})$ polynomial evaluation circuits, and is configured to perform calculation based on the received data, to obtain $(2T_s-2T_{s-1})$ target polynomials $[M(\alpha^{2T_s-1}), ..., M(\alpha^{2T_{(s-1)}})]$. It can be understood that for detailed descriptions of calculating the target polynomials by using the polynomial evaluation circuits, refer to the foregoing descriptions. Details are not described again.

The encoder 1900 further includes s constant coefficient multiply-add modules: a first constant coefficient multiply-add module, a second constant coefficient multiply-add module, ..., and an $s^{th}$ constant coefficient multiply-add module.

A preset constant coefficient of the first constant coefficient multiply-add module is $[\theta_{(j1,N_1-K_1)}, ..., \theta_{(j1,1)}]$, where $j_1=1, 2, ..., (N_1-K_1)$. It should be understood that the constant coefficient $[\theta_{(j1,N_1-K_1)}, ..., =, \theta_{(j1,1)}]$ is an $(N_1-K_1)\times(N_1-K_1)$ coefficient matrix when $j_1=[1, 2, ..., (N_1-K_1)]$. Further, the first constant coefficient multiply-add module is configured to perform calculation based on the preset constant coefficient and the received $(N_1-K_1)$ target polynomials, to obtain a corresponding check sequence $[P_{(N,-K_1-1)}, ..., p_0]$. A preset constant coefficient of the second constant coefficient multiply-add module is $[\theta_{(j2,N_2-K_2)}, ..., \theta_{(j2,1)}]$, where $j_2=1, 2, ..., (N_2-K_2)$. It should be understood that the constant coefficient $[\theta_{(j2,N_2-K_2)}, ..., \theta_{(j2,1)}]$ is an $(N_2-K_2)\times(N_2-K_2)$ coefficient matrix when $j_2=[1, 2, ..., (N_2-K_2)]$. Further, the second constant coefficient multiply-add module is configured to perform calculation based on the preset constant coefficient and the received $(N_2-K_2)$ target polynomials, to obtain a corresponding check sequence $[p_{(N_2-K_2-1)}, ..., p_0]$. A preset constant coefficient of the $s^{th}$ constant coefficient multiply-add module is $[0_{(js,N_s-K_s)}, ..., \theta_{(js,1)}]$, where $j_s=1, 2, ..., (N_s-K_s)$. It should be understood that the constant coefficient $[\theta_{(js,N_s-K_s)}, ..., \theta_{(js,1)}]$ is an $(N_s-K_s)\times(Ns-K_s)$ coefficient matrix when $j_s=[1, 2, ..., (N_s-K_s)]$. Further, the $s^{th}$ constant coefficient multiply-add module is configured to perform calculation based on the preset constant coefficient and the received $(N_s-K_s)$ target polynomials, to obtain a corresponding check sequence $[p_{(N_s-K_s-1)}, ..., p_0]$.

The encoder 1900 further includes a combination module 1910. The combination module 1910 is configured to combine the received check sequences and the corresponding to-be-encoded data, to obtain a codeword through encoding, and output the codeword.

Based on the foregoing descriptions, for the RS $(N_1, K_1, T_1, m)$ code pattern, it is assumed that data 1 includes $K_1$ symbols. The encoder 1900 sends the data 1 that needs to be encoded based on the RS $(N_1, K_1, T_1, m)$ code pattern to the first polynomial evaluation module in the encoder 1900 with a parallelism of n in $K_1/n$ cycles, to obtain $(N_1-K_1)$ (namely, $2T_1$) target polynomials $[M(\alpha^{2T_1-1}), ..., M(\alpha^0)]$ that indicate the data 1. Then, the encoder 1900 sends the $(N_1-K_1)$ target polynomials $[M(\alpha^{2T_1-1}), ..., M(\alpha^0)]$ to the first constant coefficient multiply-add module, to perform a multiply-add operation on the $(N_1-K_1)$ target polynomials $[M(\alpha^{2T_1-1}), ..., M(\alpha^0)]$ and the coefficients $[\theta_{(j1,N_1-K_1)}, ..., \theta_{(j1,1)}]$, so as to obtain a check sequence $[p_{(N_1,-K_1-1)}, ..., p_0]$ with a length of $(N_1-K_1)$ of the data 1. $p_{(N_1-K_1-1)} = \Sigma \theta_{(1,i+1)} \times M(\alpha^i)$, $p_{(N_1-K_1-2)} = \Sigma \theta_{(2,i+1)} \times M(\alpha^i)$, ..., and $p_0 = \Sigma \theta_{(N_1-K_1,i+1)} \times M(\alpha^i)$, where $i=0, 1, 2, ..., (N_1-K_1)$. Then, the encoder 1900 sends the check sequence $[p_{(N_1-K_1-1)}, ..., p_0]$ to the combination module 1910. The combination module 1910 combines the check sequence $[p_{(N,-K_1-1)}, ..., p_0]$ and the data 1, to obtain a codeword obtained by encoding the data 1 based on RS $(N_1, K_1, T_1, m)$, and outputs the codeword.

For the RS $(N_2, K_2, T_2, m)$ code pattern, it is assumed that data 2 includes $K_2$ symbols. The encoder 1900 sends the data 2 that needs to be encoded based on the RS $(N_2, K_2, T_2, m)$ code pattern to the first polynomial evaluation module and the second polynomial evaluation module with the parallelism of n in $K_2/n$ cycles. In this case, the first polynomial evaluation module may obtain, through calculation, $2T_1$ target polynomials $[M(\alpha^{2T_1-1}), ..., M(\alpha^0)]$ of the data 2 for outputting, and the second polynomial evaluation module may obtain, through calculation, $(2T_2-2T_1)$ target polynomials $[M(\alpha^{2T_2-1}), ..., M(\alpha^{2T_1})]$ of the data 2 for outputting. Then, the encoder 1900 sends the $2T_2$ target polynomials $[M(\alpha^{2T_2-1}), ..., M(\alpha^{2T_1}), M(\alpha^{2T_1-1}), ..., M(\alpha^0)]$ to the second constant coefficient multiply-add module, to perform a multiply-add operation

on the $2T_2$ target polynomials [ $M(\alpha^{2T_2-1})$, ..., $M(\alpha^{2T_1})$, $M(\alpha^{2T_1-1})$, ..., $M(\alpha^0)$ ] and the coefficients [$\theta_{(j2,N2-K2)}$, ... , $\theta_{(j2,1)}$], so as to obtain a check sequence [$p_{(N2-K2-1)}$, ..., $p_0$] of the data 2. For a detailed process of the multiply-add operation, refer to the detailed explanation of the multiply-add operation of the first constant coefficient multiply-add module. Details are not described again. Further, the encoder 1900 sends the check sequence [$p_{(N2-K2-1)}$, ..., $p_0$] to the combination module 1910. The combination module 1910 combines the check sequence [$p_{(N2-K2-1)}$, ... , $p_0$] and the data 2, to obtain a codeword obtained by encoding the data 2 based on RS ($N_2$, $K_2$, $T_2$, m), and outputs the codeword.

Similarly, for the RS ($N_s$, $K_s$, $T_s$, m) code pattern, it is assumed that data 3 includes $K_s$ symbols. The encoder 1900 sends the data 3 that needs to be encoded based on the RS ($N_s$, $K_s$, $T_s$, m) code pattern to the first polynomial evaluation module, the second polynomial evaluation module, ..., and the third polynomial evaluation module with the parallelism of n in $K_s/n$ cycles, to obtain $2T_s$ target polynomials [$M(\alpha^{2T_s-1})$, ..., $M(\alpha^{2T_s-1})$, ..., $M(\alpha^{2T_2-1})$, ..., $M(\alpha^{2T_1})$, $M(\alpha^{2T_1-1})$, ..., $M(\alpha^0)$] of the data 3. Then, the encoder 1900 performs a multiply-add operation on the $2T_s$ target polynomials and the coefficients [$\theta_{(js,N_s-K_s)}$, ..., $\theta_{(js,1)}$] by using the $s$th constant coefficient multiply-add module, to obtain a check sequence [$p_{(N_s,-K_s-1)}$, ..., $p_0$] of the data 3. Further, the encoder 1900 sends the check sequence [$p_{(N_s-K_s-1)}$, ..., $p_0$] to the combination module 1910. The combination module 1910 combines the check sequence [$p_{(N_s-K_s-1)}$, ... , $p_0$] and the data 3, to obtain a codeword obtained by encoding the data 3 based on RS ($N_s$, $K_s$, $T_s$, m), and outputs the codeword.

Based on the descriptions of the examples in FIG. 19, in embodiments of this application, when RS code patterns with different error correction capabilities are encoded, reused circuit structures (for example, the first polynomial evaluation module and the second polynomial evaluation module shown in FIG. 19) exist in the encoder for implementing the RS code patterns with different error correction capabilities. Therefore, the encoder provided in embodiments of this application can not only support encoding based on the RS code patterns with different error correction capabilities, but also reduce a circuit area and power consumption of the circuit of the encoder.

The foregoing describes the encoder provided in this application from the perspective of structure. The following describes, from the perspective of method, an encoding method performed by the foregoing encoder.

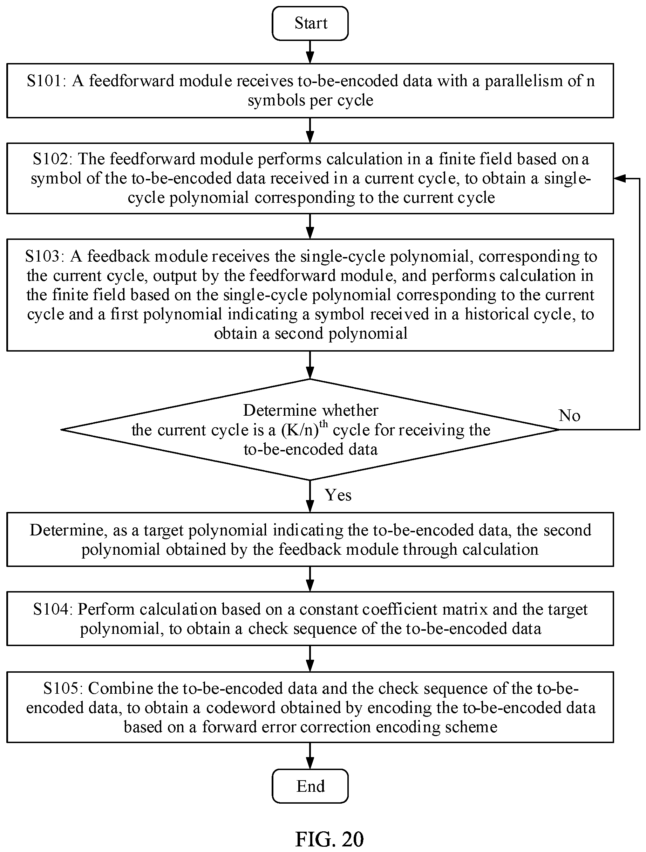

FIG. 20 is a schematic flowchart of an encoding method according to an embodiment of this application. The method is performed by the foregoing encoder (for example, the encoder shown in FIG. 8, FIG. 11, FIG. 13, FIG. 16, FIG. 18, or FIG. 19). As shown in FIG. 20, the method includes the following steps.

S101: A feedforward module receives to-be-encoded data with a parallelism of n symbols per cycle.

Herein, n is a positive integer.

Specifically, for detailed descriptions in which the encoder receives the to-be-encoded data, refer to the foregoing descriptions. Details are not described again.

S102: The feedforward module performs calculation in a finite field based on a symbol of the to-be-encoded data received in a current cycle, to obtain a single-cycle polynomial corresponding to the current cycle.

The to-be-encoded data includes K symbols, K is a positive integer, and K is greater than or equal to n. In addition, a polynomial "indicating a symbol received per cycle" is the foregoing single-cycle polynomial.

Specifically, for detailed descriptions in which the encoder obtains the single-cycle polynomial through calculation in the finite field by using the feedforward module, refer to the foregoing descriptions of calculating the single-cycle polynomial. Details are not described again.

S103: A feedback module receives the single-cycle polynomial corresponding to the current cycle output by the feedforward module, and performs calculation in the finite field based on the single-cycle polynomial corresponding to the current cycle and a first polynomial indicating a symbol received in a historical cycle, to obtain a second polynomial.

The second polynomial indicates symbols received from an initial cycle to the current cycle, and the second polynomial is used to determine a target polynomial indicating the to-be-encoded data. Herein, the initial cycle is a first cycle for the feedforward module to receive the to-be-encoded data, and the historical cycle is a cycle that is located before the current cycle in a process in which the feedforward module receives the to-be-encoded data. It should be noted that the feedback module in the encoder is decoupled from the parallelism at which the to-be-encoded data is input. For detailed descriptions, refer to the foregoing descriptions. Details are not described again.

The target polynomial is used to generate a check sequence of the to-be-encoded data, the check sequence of the to-be-encoded data is used to check and correct the to-be-encoded data, and a codeword obtained by encoding the to-be-encoded data based on a forward error correction encoding scheme includes the to-be-encoded data and the check sequence of the to-be-encoded data.

Specifically, for detailed descriptions in which the encoder uses the feedback module to receive the single-cycle polynomial corresponding to the current cycle output by the feedforward module, and perform calculation in the finite field based on the single-cycle polynomial corresponding to the current cycle and a first polynomial indicating a symbol received in a historical cycle, to obtain a second polynomial for outputting, refer to the foregoing detailed descriptions about the feedback circuit. Details are not described again.

Further, the encoder determines whether the current cycle is a $(K/n)$th cycle for receiving the to-be-encoded data.

When the encoder determines that the current cycle is the $(K/n)$th cycle for receiving the to-be-encoded data, it indicates that an input of a payload of one codeword has been completed. In this case, the encoder determines, as the target polynomial indicating the to-be-encoded data, the second polynomial obtained by the feedback module through calculation, and the encoder performs S104.

When the encoder determines that the current cycle is not the $(K/n)^{th}$ cycle for receiving the to-be-encoded data, it indicates that the input of the payload of one codeword is not completed. In this case, the encoder repeatedly performs S102 and S103 until the $(K/n)^{th}$ cycle for receiving the to-be-encoded data.

S104: Perform calculation based on a constant coefficient matrix and the target polynomial, to obtain the check sequence of the to-be-encoded data.

For detailed descriptions in which the encoder performs calculation based on the constant coefficient matrix and the target polynomial, to obtain the check sequence of the to-be-encoded data, refer to the foregoing detailed descriptions about the constant coefficient multiply-add module. Details are not described again.

S105: Combine the to-be-encoded data and the check sequence of the to-be-encoded data, to obtain the codeword obtained by encoding the to-be-encoded data based on the forward error correction encoding scheme.

For detailed descriptions in which the encoder combines the to-be-encoded data and the check sequence of the to-be-encoded data, to obtain the codeword obtained by encoding the to-be-encoded data based on the forward error correction encoding scheme, refer to the foregoing detailed descriptions about the combination module. Details are not described again.

Therefore, the encoder provided in embodiments of this application can encode forward error correction code patterns with different error correction capabilities according to the encoding method described in S101 to S105, and reduce a circuit area and power consumption of the circuit of the encoder.

To better understand the encoder and the encoding method in embodiments of this application, the following provides further descriptions by using specific examples.

Example 1: RS (528, 514, 7, 10) code pattern

The RS (528, 514, 7, 10) code pattern indicates that a length of an RS codeword is 528, a payload length in the codeword is 514, a length (528-514) of a check sequence is 14 (namely, (N-K) in the foregoing), an error correction capability is 7, and a finite field for RS encoding calculation is $GF(2^{10})$.

According to the foregoing encoding method, the encoder provided in this application performs encoding based on the RS (528, 514, 7, 10) code pattern. A constant coefficient matrix preset in the constant coefficient multiply-add module in the encoder is denoted as the following matrix (3):

$$\text{Matrix (3)} \begin{bmatrix} \theta_{1,1} & \theta_{1,2} & \cdots & \theta_{1,14} \\ \theta_{2,1} & \theta_{2,2} & \cdots & \theta_{2,14} \\ \vdots & \vdots & \ddots & \vdots \\ \theta_{14,1} & \theta_{14,2} & \cdots & \theta_{14,14} \end{bmatrix}$$

In this case, 14 polynomial evaluation modules in the encoder obtain 14 target polynomials: $[M(\alpha^{13}), M(\alpha^{12}), ..., M(\alpha^{0})]$ of the to-be-encoded data through calculation. Then, the constant coefficient multiply-add module in the encoder performs a multiply-add operation on $[M(\alpha^{13}), M(\alpha^{12}), ..., M(\alpha^{0})]$ and the preset constant coefficient matrix (namely, the matrix (3)), to obtain a check sequence $[p_{13}, p_{12} ..., p_0]$. $p_{13} = \Sigma \theta_{(1,i+1)} \times M(\alpha^i)$, $p_{12} = \Sigma \theta_{(2,i+1)} \times M(\alpha^i)$, ..., and $p_0 = \Sigma \theta_{(14,i+1)} \times M(\alpha^i)$, where i=1, 2, ..., 14.

A value of $[M(\alpha^{13}), M(\alpha^{12}), ..., M(\alpha^{0})]$ may be calculated according to the following formula (21) and a root $\alpha$ of a primitive polynomial $x^{10}+x^3+1$ in the finite field $GF(2^{10})$:

$$\text{Formula (21)} \begin{cases} M(\alpha^{13}) = m_{513} \cdot (\alpha^{13})^{513} + m_{512} \cdot (\alpha^{13})^{512} + \cdots + m_1 \cdot (\alpha^{13})^1 + m_0 \cdot (\alpha^{13})^0 \\ M(\alpha^{12}) = m_{513} \cdot (\alpha^{12})^{513} + m_{512} \cdot (\alpha^{12})^{512} + \cdots + m_1 \cdot (\alpha^{12})^1 + m_0 \cdot (\alpha^{12})^0 \\ \vdots \\ M(\alpha^0) = m_{513} \cdot (\alpha^0)^{513} + m_{512} \cdot (\alpha^0)^{512} + \cdots + m_1 \cdot (\alpha^0)^1 + m_0 \cdot (\alpha^0)^0 \end{cases}$$

Each coefficient of the matrix (3) may be obtained through calculation according to the following formula (22) and the root $\alpha$ of the primitive polynomial $x^{10}+x^3+1$ in the finite field $GF(2^{10})$. The formula (22) may be derived according to the formula (13) and the matrix (3). Details are not described again.

$$\text{Formula (22)} \begin{bmatrix} \theta_{1,1} & \theta_{1,2} & \cdots & \theta_{1,14} \\ \theta_{2,1} & \theta_{2,2} & \cdots & \theta_{2,14} \\ \vdots & \vdots & \ddots & \vdots \\ \theta_{14,1} & \theta_{14,2} & \cdots & \theta_{14,14} \end{bmatrix}^{-1} = \begin{bmatrix} (\alpha^0)^{-1} & (\alpha^0)^{-2} & \cdots & (\alpha^0)^{-14} \\ (\alpha^1)^{-1} & (\alpha^1)^{-2} & \cdots & (\alpha^1)^{-14} \\ \vdots & \vdots & \ddots & \vdots \\ (\alpha^{13})^{-1} & (\alpha^{13})^{-2} & \cdots & (\alpha^{13})^{-14} \end{bmatrix}^{-1}$$

Coefficients, obtained through pre-calculation, of the matrix (3) are specifically shown in the following matrix (4):

Matrix (4)

$$\begin{bmatrix} 1 & 1 & 1 & 1 & 1 & 1 & 1 & 1 & 1 & 1 & 1 & 1 & 1 & 1 \\ 516 & 258 & 129 & 580 & 290 & 145 & 588 & 294 & 147 & 589 & 802 & 401 & 716 & 358 \\ 258 & 580 & 145 & 294 & 589 & 401 & 358 & 605 & 402 & 359 & 863 & 977 & 502 & 633 \\ 129 & 145 & 147 & 401 & 179 & 405 & 695 & 977 & 251 & 412 & 567 & 961 & 249 & 158 \\ 580 & 294 & 401 & 605 & 359 & 977 & 633 & 103 & 961 & 632 & 547 & 743 & 1001 & 126 \\ 290 & 589 & 179 & 359 & 1004 & 412 & 907 & 632 & 789 & 959 & 252 & 896 & 28 & 903 \\ 145 & 401 & 405 & 977 & 412 & 961 & 158 & 743 & 504 & 896 & 14 & 999 & 508 & 452 \\ 588 & 358 & 695 & 633 & 907 & 158 & 887 & 126 & 112 & 903 & 1016 & 452 & 805 & 618 \\ 294 & 605 & 977 & 103 & 632 & 743 & 126 & 56 & 999 & 127 & 286 & 442 & 942 & 377 \\ 147 & 405 & 251 & 961 & 789 & 504 & 112 & 999 & 571 & 579 & 309 & 957 & 559 & 301 \\ 589 & 359 & 412 & 632 & 959 & 896 & 903 & 127 & 579 & 670 & 493 & 962 & 336 & 983 \\ 802 & 863 & 567 & 547 & 252 & 14 & 1016 & 286 & 309 & 493 & 481 & 84 & 1021 & 687 \\ 401 & 977 & 961 & 743 & 896 & 999 & 452 & 442 & 957 & 962 & 84 & 1018 & 941 & 740 \\ 716 & 502 & 249 & 1001 & 28 & 508 & 805 & 942 & 559 & 336 & 1021 & 941 & 370 & 842 \end{bmatrix}^{-1}$$

Further, the encoder performs calculation based on the value, of $[M(\alpha^{13}), M(\alpha^{12}), ..., M(\alpha^0)]$, obtained through calculation according to the formula (21), and the coefficients shown in the matrix (4), to obtain the check sequence $[p_{13}, p_{12} ..., p_0]$. The encoder combines the to-be-encoded data and the check sequence, to obtain the codeword by encoding the to-be-encoded data based on the RS (528, 514, 7, 10) code pattern.

Example 2: RS (544, 514, 15, 10)

The RS (544, 514, 15, 10) code pattern indicates that a length of an RS codeword is 544, a payload length in the codeword is 514, a length (544-514) of a check sequence is 30 (namely, (N-K) in the foregoing), an error correction capability is 15, and a finite field for RS encoding calculation is $GF(2^{10})$.

According to the foregoing encoding method, the encoder provided in this application performs encoding based on the RS (544, 514, 15, 10) code pattern. A constant coefficient matrix preset in the constant coefficient multiply-add module in the encoder is denoted as the following matrix (5):

$$\text{Matrix (5)} \begin{bmatrix} \theta_{1,1} & \theta_{1,2} & \cdots & \theta_{1,30} \\ \theta_{2,1} & \theta_{2,2} & \cdots & \theta_{2,30} \\ \vdots & \vdots & \ddots & \vdots \\ \theta_{30,1} & \theta_{30,2} & \cdots & \theta_{30,30} \end{bmatrix}$$

In this case, 30 polynomial evaluation modules in the encoder obtain 30 target polynomials: $[M(\alpha^{29}), ..., M(\alpha^0)]$ of the to-be-encoded data through calculation. Then, the constant coefficient multiply-add module in the encoder performs a multiply-add operation on $[M(\alpha^{29}), ..., M(\alpha^0)]$ and the preset constant coefficient matrix (namely, the matrix (5)), to obtain a check sequence $[p_{29}, p_{28} ..., p_0]$. $P_{29} = \Sigma \theta_{(1,i+1)} \times M(\alpha^i)$, $p_{28} = \Sigma \theta_{(2,i+1)} \times M(\alpha^i)$, ..., and $p_0 = \Sigma \theta_{(30,i+1)} \times M(\alpha^i)$, where i=1, 2, ..., 30.

A value of $[M(\alpha^{29}), ..., M(\alpha^0)]$ may be calculated according to the following formula (23) and a root $\alpha$ of a primitive polynomial $x^{10}+x^3+1$ in the finite field $GF(2^{10})$:

$$\text{Formula (23)} \begin{cases} M(\alpha^{29}) = m_{513} \cdot (\alpha^{29})^{513} + m_{512} \cdot (\alpha^{29})^{512} + \cdots + m_1 \cdot (\alpha^{29})^1 + m_0 \cdot (\alpha^{29})^0 \\ \vdots \\ M(\alpha^{13}) = m_{513} \cdot (\alpha^{13})^{513} + m_{512} \cdot (\alpha^{13})^{512} + \cdots + m_1 \cdot (\alpha^{13})^1 + m_0 \cdot (\alpha^{13})^0 \\ \vdots \\ M(\alpha^0) = m_{513} \cdot (\alpha^0)^{513} + m_{512} \cdot (\alpha^0)^{512} + \cdots + m_1 \cdot (\alpha^0)^1 + m_0 \cdot (\alpha^0)^0 \end{cases}$$

It can be learned from the formula (21) and the formula (23) that, in a process in which the encoder performs encoding based on the RS (544, 514, 15, 10) code pattern, when the encoder calculates $[M(\alpha^{29}), ..., M(\alpha^0)]$ by using the 30 polynomial evaluation circuits, the 14 polynomial evaluation circuits corresponding to $[M(\alpha^{13}), ..., M(\alpha^0)]$ in RS (528, 514, 7, 10) can be reused. This can reduce a circuit area and power consumption of the circuit.

Each coefficient of the matrix (5) may be obtained through calculation according to the following formula (24) and the root $\alpha$ of the primitive polynomial $x^{10}+x^3+1$ in the finite field $GF(2^{10})$. The formula (24) may be derived according to the formula (13) and the matrix (5). Details are not described again.

$$\text{Formula (24)} \begin{bmatrix} \theta_{1,1} & \theta_{1,2} & \cdots & \theta_{1,30} \\ \theta_{2,1} & \theta_{2,2} & \cdots & \theta_{2,30} \\ \vdots & \vdots & \ddots & \vdots \\ \theta_{30,1} & \theta_{30,2} & \cdots & \theta_{30,30} \end{bmatrix}^{-1} = \begin{bmatrix} (\alpha^0)^{-1} & (\alpha^0)^{-2} & \cdots & (\alpha^0)^{-30} \\ (\alpha^1)^{-1} & (\alpha^1)^{-2} & \cdots & (\alpha^1)^{-30} \\ \vdots & \vdots & \ddots & \vdots \\ (\alpha^{29})^{-1} & (\alpha^{29})^{-2} & \cdots & (\alpha^{29})^{-30} \end{bmatrix}^{-1}$$

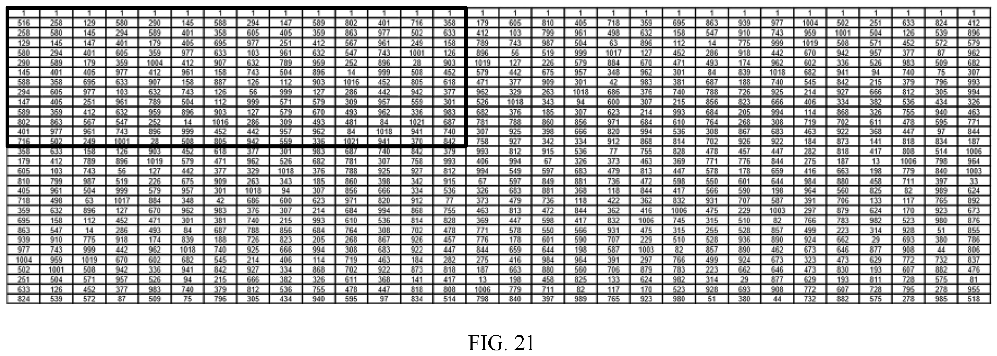

After calculation, refer to FIG. 21. FIG. 21 shows a constant coefficient matrix for an RS (544, 514, 15, 10) code pattern according to an embodiment of this application. In comparison with the coefficients of the RS (528, 514) code pattern and the RS (544, 514) code pattern in the current encoding method shown in Table 1, FIG. 21 shows a submatrix of the first 14 rows and the first 14 columns (shown in a bold black rectangular box in FIG. 21) in the constant coefficient matrix that is of the RS (544, 514, 15, 10) code pattern and that is preset in the encoder provided in embodiments of this application. The submatrix is the constant coefficient matrix that is of the RS (528, 514, 7, 10) code pattern and that is preset in the encoder provided in embodiments of this application. In view of this, based on the same coefficient matrix, the encoder for the RS (544, 514, 15, 10) code pattern and the encoder for the RS (528, 514, 7, 10) code pattern provided in embodiments of this application can share a circuit constructed based on the foregoing same coefficient matrix. Therefore, the encoder provided in embodiments of this application can encode forward error correction code patterns with different error correction capabilities, and a circuit area and power consumption of the encoder can be reduced.

Further, the encoder performs calculation based on the value, of $[M(\alpha^{29}), ..., M(\alpha^0)]$, obtained through calculation according to the formula (23), and the coefficients shown in the FIG. 21, to obtain the check sequence $[p_{29}, p_{28} ..., p_0]$. The encoder combines the to-be-encoded data and the check sequence, to obtain the codeword by encoding the to-be-encoded data based on the RS (544, 514, 15, 10) code pattern.

In conclusion, the encoder provided in embodiments of this application does not have a technical defect in which a timing closure is not achieved in a scenario of large bandwidth and an input at high parallelism. In addition, the encoder provided in embodiments of this application can encode forward error correction code patterns with different error correction capabilities, and can reduce a circuit area and power consumption of the encoder.

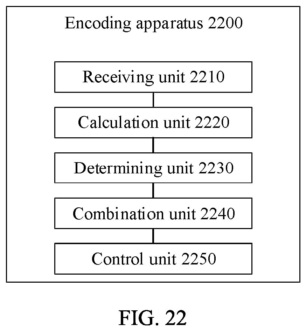

To implement the functions described in the foregoing method, FIG. 22 is a diagram of a structure of an encoding apparatus 2200 according to an embodiment of this application. The encoding apparatus 2200 is configured to perform the foregoing encoding method, for example, configured to perform the method shown in FIG. 20. The encoding apparatus 2200 may be the foregoing encoder including the feedforward module and the feedback module described above, or the encoding apparatus 2200 is used in the foregoing encoder including the feedforward module and the feedback module. The encoding apparatus 2200 may include a receiving unit 2210 and a calculation unit 2220.

The receiving unit 2210 is configured to use a feedforward module to receive to-be-encoded data with a parallelism of n symbols per cycle, where n is a positive integer. The calculation unit 2220 is configured to use the feedforward module to perform calculation in a finite field based on a symbol of the to-be-encoded data received in a current cycle, to obtain a single-cycle polynomial corresponding to the current cycle. The single-cycle polynomial indicates a symbol received by the feedforward module in one cycle. The calculation unit 2220 is further configured to use a feedback module to receive the single-cycle polynomial corresponding to the current cycle output by the feedforward module, and perform calculation in the finite field based on the single-cycle polynomial corresponding to the current cycle and a first polynomial indicating a symbol received in a historical cycle, to obtain a second polynomial. The second polynomial indicates symbols received from an initial cycle to the current cycle, and the second polynomial is used to determine a target polynomial indicating the to-be-encoded data. The target polynomial is used to generate a check sequence of the to-be-encoded data, the check sequence of the to-be-encoded data is used to check and correct the to-be-encoded data, and a codeword obtained by encoding the to-be-encoded data based on a forward error correction encoding scheme includes the to-be-encoded data and the check sequence of the to-be-encoded data. In addition, the initial cycle is a first cycle for the feedforward module to receive the to-be-encoded data, and the historical cycle is a cycle that is located before the current cycle in a process in which the feedforward module receives the to-be-encoded data.

For example, with reference to FIG. 20, the receiving unit 2210 may be configured to perform S101, and the calculation unit 2220 may be configured to perform S102 and S103.

Optionally, the to-be-encoded data includes K symbols, and K is a positive integer. When a length of the codeword obtained by encoding the to-be-encoded data based on the forward error correction encoding scheme is N, and N is an integer greater than K, the encoder includes N-K polynomial evaluation modules, and each polynomial evaluation module includes the feedforward module and the feedback module. The N-K polynomial evaluation modules are configured to perform calculation in the finite field by using the feedforward module and the feedback module in each polynomial evaluation module, to obtain N-K target polynomials indicating the to-be-encoded data.

Optionally, when the length of the codeword obtained by encoding the to-be-encoded data based on the forward error correction encoding scheme is N+$\Delta$N, the encoder includes N+$\Delta$N-K polynomial evaluation modules, and each polynomial evaluation module includes the feedforward module and the feedback module. The N+$\Delta$N-K polynomial evaluation modules are configured to perform calculation in the finite field by using the feedforward module and the feedback module in each polynomial evaluation module, to obtain N+$\Delta$N-K target polynomials indicating the to-be-encoded data. In addition, the N+$\Delta$N-K polynomial evaluation modules include the N-K polynomial evaluation modules.

Optionally, the encoding apparatus 2200 further includes a determining unit 2230, configured to: when determining that the current cycle is a $(K/n)^{th}$ cycle for receiving the to-be-encoded data, determine the second polynomial as the target polynomial, where the calculation unit 2220 is further configured to perform calculation based on a constant coefficient matrix and the target polynomial, to obtain the check sequence of the to-be-encoded data; and a combination unit 2240, configured to combine the to-be-encoded data and the check sequence of the to-be-encoded data, to obtain the codeword obtained by encoding the to-be-encoded data based on the forward error correction encoding scheme.

For example, with reference to FIG. 20, the calculation unit 2220 may be configured to perform S104, and the combination unit 2240 may be configured to perform S105.

Optionally, when the length of the codeword obtained by encoding the to-be-encoded data based on the forward error correction encoding scheme is N, the constant coefficient matrix is an (N-K)$\times$(N-K) first constant coefficient matrix; and when the length of the codeword obtained by encoding the to-be-encoded data based on the forward error correction encoding scheme is N+$\Delta$N, the constant coefficient matrix is a (N+$\Delta$N-K)$\times$(N+$\Delta$N-K) second constant coefficient matrix. The second constant coefficient matrix includes the first constant coefficient matrix.

Optionally, the encoder supports encoding of at least one forward error correction code pattern, and each of the at least one forward error correction code pattern has a different error correction capability.

Optionally, when a value of n is greater than a threshold, the encoding apparatus 2200 further includes a control unit 2250, configured to use a register inserted into the feedforward module to control the feedforward module to complete calculation of a single-cycle polynomial in at least two clock cycles.

For detailed descriptions of the foregoing optional implementations, refer to the foregoing method embodiments. Details are not described herein again. In addition, for the explanation and beneficial effect of any encoding apparatus 2200 provided above, refer to the corresponding method and embodiments for describing the encoder. Details are not described again.

For example, with reference to FIG. 12, a function implemented by the receiving unit 2210 in the encoding apparatus 2200 may be performed by the polynomial evaluation circuit in FIG. 12. A function implemented by the calculation unit 2220 may be performed by the polynomial evaluation circuit and the constant coefficient multiply-add module 1210 shown in FIG. 12. A function implemented by the determining unit 2230 may be performed by the polynomial evaluation circuit shown in FIG. 12. A function implemented by the combination unit 2240 may be performed by the combination module 1220 shown in FIG. 12. With reference to FIG. 14, a function implemented by the control unit 2250 may be performed by the register inserted into the feedforward circuit 1400 in FIG. 14.

A person skilled in the art should easily be aware that, in combination with units and algorithm steps of the examples described in embodiments disclosed in this specification, this application may be implemented by hardware or a combination of hardware and computer software. Whether a function is executed by hardware or hardware driven by computer software depends on particular applications and design constraint conditions of the technical solutions. A person skilled in the art may use different methods to implement the described functions for each specific application. However, it should not be considered that the implementation goes beyond the scope of this application.

It should be noted that, in this application, division into the modules in FIG. 22 is an example, is merely logical function division, and may be other division during actual implementation. For example, two or more functions may be integrated into one processing module. The integrated module may be implemented in a form of hardware, or may be implemented in a form of a software functional module.

An embodiment of this application further provides a chip. The chip includes an encoding circuit. The encoding circuit is configured to perform the foregoing encoding method, to encode to-be-encoded data based on a forward error correction encoding scheme.

An embodiment of this application further provides a computer program product and a computer-readable storage medium configured to store the computer program product. The computer program product may include one or more program instructions. When the one or more program instructions are run by one or more processors, the foregoing functions or some of the functions described with respect to FIG. 20 may be provided. Therefore, for example, one or more features in S101 to S105 in FIG. 20 may be implemented by using one or more instructions in the computer program product.

In some examples, the encoding apparatus described for FIG. 20 may be configured to provide various operations, functions, or actions in response to the one or more program instructions stored in the computer-readable storage medium.

All or some of the foregoing embodiments may be implemented by using software, hardware, firmware, or any combination thereof. When a software program is used to implement embodiments, embodiments may be implemented completely or partially in a form of a computer program product. The computer program product includes one or more computer instructions. When the computer executable instructions are executed on a computer, all or some of the procedures or functions according to embodiments of this application are generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by a computer, or a data storage device, for example, a server or a data center, integrating one or more usable media. The usable medium may be a magnetic medium (for example, a floppy disk, a hard disk, or a magnetic tape), an optical medium (for example, a DVD), a semiconductor medium (for example, a solid-state disk (solid-state disk, SSD)), or the like.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

**Claims**

1. An encoder, comprising:

   a feedforward module, configured to receive to-be-encoded data with a parallelism of n symbols per cycle, and perform calculation in a finite field based on a symbol of the to-be-encoded data received in a current cycle, to obtain a single-cycle polynomial corresponding to the current cycle, wherein the single-cycle polynomial indicates a symbol received by the feedforward module in one cycle, and n is a positive integer; and
   a feedback module, configured to receive the single-cycle polynomial corresponding to the current cycle output by the feedforward module, and perform calculation in the finite field based on the single-cycle polynomial corresponding to the current cycle and a first polynomial indicating a symbol received in a historical cycle, to obtain a second polynomial, wherein the second polynomial indicates symbols received from an initial cycle to the current cycle, the second polynomial is used to determine a target polynomial indicating the to-be-encoded data, the target polynomial is used to generate a check sequence of the to-be-encoded data, the check sequence of the to-be-encoded data is used to check and correct the to-be-encoded data, a codeword obtained by encoding the to-be-encoded data based on a forward error correction encoding scheme comprises the to-be-encoded data and the check sequence of the to-be-encoded data, the initial cycle is a first cycle for the feedforward module to receive the to-be-encoded data, and the historical cycle is a cycle that is located before the current cycle in a process in which the feedforward module receives the to-be-encoded data.

2. The encoder according to claim 1, wherein the to-be-encoded data comprises K symbols, and K is a positive integer; and when a length of the codeword obtained by encoding the to-be-encoded data based on the forward error correction encoding scheme is N, and N is an integer greater than K, the encoder comprises N-K polynomial evaluation modules, and each polynomial evaluation module comprises the feedforward module and the feedback module; and
   the N-K polynomial evaluation modules are configured to perform calculation in the finite field by using the feedforward module and the feedback module in each polynomial evaluation module, to obtain N-K target polynomials indicating the to-be-encoded data.

3. The encoder according to claim 2, wherein when the length of the codeword obtained by encoding the to-be-encoded data based on the forward error correction encoding scheme is N+ΔN, the encoder comprises N+ΔN-K polynomial evaluation modules, and each polynomial evaluation module comprises the feedforward module and the feedback module; and
the N+ΔN-K polynomial evaluation modules are configured to perform calculation in the finite field by using the feedforward module and the feedback module in each polynomial evaluation module, to obtain N+ΔN-K target polynomials indicating the to-be-encoded data, wherein the N+ΔN-K polynomial evaluation modules comprise the N-K polynomial evaluation modules.

4. The encoder according to any one of claims 1 to 3, wherein the encoder further comprises:

a constant coefficient multiply-add module, configured to perform calculation based on a constant coefficient matrix and the target polynomial, to obtain the check sequence of the to-be-encoded data; and
a combination module, configured to combine the to-be-encoded data and the check sequence of the to-be-encoded data, to obtain the codeword obtained by encoding the to-be-encoded data based on the forward error correction encoding scheme.

5. The encoder according to claim 4, wherein

when the length of the codeword obtained by encoding the to-be-encoded data based on the forward error correction encoding scheme is N, the constant coefficient matrix is an (N-K)×(N-K) first constant coefficient matrix; and
when the length of the codeword obtained by encoding the to-be-encoded data based on the forward error correction encoding scheme is N+ΔN, the constant coefficient matrix is an (N+ΔN-K)×(N+ΔN-K) second constant coefficient matrix, and the second constant coefficient matrix comprises the first constant coefficient matrix.

6. The encoder according to any one of claims 1 to 5, wherein the encoder supports encoding of at least one forward error correction code pattern, and each of the at least one forward error correction code pattern has a different error correction capability.

7. The encoder according to any one of claims 1 to 6, wherein when a value of n is greater than a threshold, the feedforward module comprises a register; and
the register is configured to control the feedforward module to complete calculation of a single-cycle polynomial in at least two clock cycles.

8. An encoding method, wherein the method is applied to an encoder, the encoder comprises a feedforward module and a feedback module, and the method comprises:

receiving, by the feedforward module, to-be-encoded data with a parallelism of n symbols per cycle, and performing calculation in a finite field based on a symbol of the to-be-encoded data received in a current cycle, to obtain a single-cycle polynomial corresponding to the current cycle, wherein the single-cycle polynomial indicates a symbol received by the feedforward module in one cycle, and n is a positive integer; and
receiving, by the feedback module, the single-cycle polynomial corresponding to the current cycle output by the feedforward module, and performing calculation in the finite field based on the single-cycle polynomial corresponding to the current cycle and a first polynomial indicating a symbol received in a historical cycle, to obtain a second polynomial, wherein the second polynomial indicates symbols received from an initial cycle to the current cycle, the second polynomial is used to determine a target polynomial indicating the to-be-encoded data, the target polynomial is used to generate a check sequence of the to-be-encoded data, the check sequence of the to-be-encoded data is used to check and correct the to-be-encoded data, a codeword obtained by encoding the to-be-encoded data based on a forward error correction encoding scheme comprises the to-be-encoded data and the check sequence of the to-be-encoded data, the initial cycle is a first cycle for the feedforward module to receive the to-be-encoded data, and the historical cycle is a cycle that is located between the current cycle in a process in which the feedforward module receives the to-be-encoded data.

9. The method according to claim 8, wherein the to-be-encoded data comprises K symbols, and K is a positive integer;

when a length of the codeword obtained by encoding the to-be-encoded data based on the forward error correction encoding scheme is N, and N is an integer greater than K, the encoder comprises N-K polynomial evaluation modules, and each polynomial evaluation module comprises the feedforward module and the feedback module; and the N-K polynomial evaluation modules are configured to perform calculation in the finite field by using the feedforward module and the feedback module in each polynomial evaluation module, to obtain N-K target polynomials indicating the to-be-encoded data.

10. The method according to claim 9, wherein when the length of the codeword obtained by encoding the to-be-encoded data based on the forward error correction encoding scheme is $N+\Delta N$, the encoder comprises $N+\Delta N$-K polynomial evaluation modules, and each polynomial evaluation module comprises the feedforward module and the feedback module; and the $N+\Delta N$-K polynomial evaluation modules are configured to perform calculation in the finite field by using the feedforward module and the feedback module in each polynomial evaluation module, to obtain $N+\Delta N$-K target polynomials indicating the to-be-encoded data, wherein the $N+\Delta N$-K polynomial evaluation modules comprise the N-K polynomial evaluation modules.

11. The method according to any one of claims 8 to 10, wherein the method further comprises:

when determining that the current cycle is a $(K/n)^{th}$ cycle for receiving the to-be-encoded data, determining the second polynomial as the target polynomial;
performing calculation based on a constant coefficient matrix and the target polynomial, to obtain the check sequence of the to-be-encoded data; and
combining the to-be-encoded data and the check sequence of the to-be-encoded data, to obtain the codeword obtained by encoding the to-be-encoded data based on the forward error correction encoding scheme.

12. The method according to claim 11, wherein

when the length of the codeword obtained by encoding the to-be-encoded data based on the forward error correction encoding scheme is N, the constant coefficient matrix is an $(N-K)\times(N-K)$ first constant coefficient matrix; and
when the length of the codeword obtained by encoding the to-be-encoded data based on the forward error correction encoding scheme is $N+\Delta N$, the constant coefficient matrix is an $(N+\Delta N-K)\times(N+\Delta N-K)$ second constant coefficient matrix, and the second constant coefficient matrix comprises the first constant coefficient matrix.

13. The encoding method according to any one of claims 8 to 12, wherein the encoder supports encoding of at least one forward error correction code pattern, and each of the at least one forward error correction code pattern has a different error correction capability.

14. The method according to any one of claims 8 to 13, wherein when a value of n is greater than a threshold, the method further comprises:
controlling, by a register inserted into the feedforward module, the feedforward module to complete calculation of a single-cycle polynomial in at least two clock cycles.

15. A chip, wherein the chip comprises an encoding circuit, and the encoding circuit is configured to perform the method according to any one of claims 8 to 14, to encode to-be-encoded data based on a forward error correction encoding scheme.

EP 4 765 695 A1

$g_0$ $g_1$ $g_2$ $g_{N-K-1}$

$x_1(n)$ $x_2(n)$ $x_{N-K}(n)$

Circuit 10

Input a payload symbol

0 1

Output an RS codeword

Register

Multiplier

Adder

0 1 Multiplexer

FIG. 1

FIG. 2

Input to-be-encoded data with a parallelism of n per cycle → Encoder → Codeword obtained by encoding the to-be-encoded data → Transmit/Store

FIG. 3

| MAC |
| PCS |
| PMA |
| PMD |

PHY (brackets PCS, PMA, PMD)

FIG. 4

Higher layer in an Ethernet architecture

⋮

Higher sublayer at the data link layer

MAC sublayer

Reconciliation sublayer (reconciliation sublayer)

| Application (application) layer |
| Presentation (presentation) layer |
| Session (session) layer |
| Transport (transport) layer |
| Network (network) layer |
| Data link (data link) layer |
| Physical (physical) layer |

| PCS |
| PMA |
| PMD |

PHY

FIG. 5

Encoding system 60

Control inputting of
to-be-encoded data
with a parallelism of n
symbols per cycle

Output the
encoded data

| Controller 610 | Encoder 620 |

FIG. 6

710

70

Processor

CPU 0

CPU 1

730

Encoder

720

Memory

Program
instructions

Bus 750

Network/Communication
interface

740

Receiving unit

Sending unit

FIG. 7

FIG. 8

FIG. 9

FIG. 10

$(K/n)^{th}$ cycle    ...    Second cycle    First cycle

Encoder 80

| | | | |
|---|---|---|---|
| $m_{n-1}$ | ... | $m_{K-n-1}$ | $m_{K-1}$ |
| $m_{n-2}$ | ... | $m_{K-n-2}$ | $m_{K-2}$ |
| $\vdots$ | ... | $\vdots$ | $\vdots$ |
| $m_1$ | ... | $m_{K-2n-1}$ | $m_{K-n-1}$ |
| $m_{K-n \times K/n}$ | ... | $m_{K-2n}$ | $m_{K-n}$ |

Polynomial evaluation circuit 0 (feedforward circuit+feedback circuit) — $M(\alpha^0)$

Polynomial evaluation circuit 1 (feedforward circuit+feedback circuit) — $M(\alpha^1)$

...

Polynomial evaluation circuit $(N-K-2)$ (feedforward circuit+feedback circuit) — $M(\alpha^{N-K-2})$

Polynomial evaluation circuit $(N-K-1)$ (feedforward circuit+feedback circuit) — $M(\alpha^{N-K-1})$

FIG. 11

Input a
payload
with a
parallelism
of n

Encoder 80

| N–K polynomial evaluation circuits | → | Constant coefficient multiply-add module 1210 | → | Combination module 1220 |

Codeword
(payload+check sequence)

FIG. 12

$(K/n)^{th}$ cycle  ···  Second cycle  First cycle

$m_{n-1}$  ···  $m_{K-n-1}$  $m_{K-1}$

$m_{n-2}$  ···  $m_{K-n-2}$  $m_{K-2}$

⋮  ···  ⋮  ⋮

$m_1$  $m_{K-2n-1}$  $m_{K-n-1}$

$m_{K-n \times K/n}$  ···  $m_{K-2n}$  $m_{K-n}$

N–K polynomial evaluation circuits

Polynomial evaluation circuit 0 (feedforward circuit+feedback circuit)

Polynomial evaluation circuit 1 (feedforward circuit+feedback circuit)

···

Polynomial evaluation circuit (N–K–2) (feedforward circuit+feedback circuit)

Polynomial evaluation circuit (N–K–1) (feedforward circuit+feedback circuit)

$M(\alpha^0)$

$M(\alpha^1)$

⋮

$M(\alpha^{N-K-2})$

$M(\alpha^{N-K-1})$

Constant coefficient multiply-add module 1210

Submodule 0 (corresponding to coefficients $\theta_{1,1}$ to $\theta_{1,N-K}$)

Submodule 1 (corresponding to coefficients $\theta_{2,1}$ to $\theta_{2,N-K}$)

⋮

Submodule (N–K–2) (corresponding to coefficients $\theta_{N-K-1,1}$ to $\theta_{N-K-1,N-K}$)

Submodule (N–K–1) (corresponding to coefficients $\theta_{N-K,1}$ to $\theta_{N-K,N-K}$)

$P_{N-K-1}$

$P_{N-K-2}$

⋮

$P_1$

$P_0$

Combination module 1220

FIG. 13

EP 4 765 695 A1

Fourth | Third | Second | First
cycle | cycle | cycle | cycle

Feedforward circuit 1400

Subcircuit 1410

$0$ | $m_3$ | $m_7$ | $m_{11}$

$(\alpha^i)^3$

$0$ | $m_2$ | $m_6$ | $m_{10}$

$(\alpha^i)^2$

Register 1401

Subcircuit 1420

$m_1$ | $m_5$ | $m_8$ | $0$

$(\alpha^i)^1$

$m_0$ | $m_4$ | $m_9$ | $0$

$(\alpha^i)^0$

Output a single-cycle polynomial from the second cycle

Feedback circuit

⊗ Multiplier

⊞ Adder

FIG. 14

$$\Phi_{N+\Delta N,K}$$

$$\Phi_{N,K}$$

$$\begin{bmatrix} M(\alpha^0) \\ M(\alpha^1) \\ M(\alpha^2) \\ \vdots \\ M(\alpha^{N-K-1}) \\ M(\alpha^{N-K}) \\ \vdots \\ M(\alpha^{N+\Delta N-K-1}) \end{bmatrix}$$

FIG. 15

FIG. 16

EP 4 765 695 A1

$$\Theta_{N,K} \qquad\qquad \Theta_{N+\Delta N,K}$$

$$\begin{bmatrix} \theta_{1,1} & \theta_{1,2} & \cdots & \theta_{1,N-K} & \theta_{1,N+1-K} & \cdots & \theta_{1,N+\Delta N-K} \\ \theta_{2,1} & \theta_{2,2} & \cdots & \theta_{2,N-K} & \theta_{2,N+1-K} & \cdots & \theta_{2,N+\Delta N-K} \\ \vdots & \vdots & \ddots & \vdots & \vdots & \ddots & \vdots \\ \theta_{N-K,1} & \theta_{N-K,2} & \cdots & \theta_{N-K,N-K} & \theta_{N-K,N+1-K} & \cdots & \theta_{N-K,N+\Delta N-K} \\ \theta_{N+1-K,1} & \theta_{N+1-K,2} & \cdots & \theta_{N+1-K,N-K} & \theta_{N+1-K,N+1-K} & \cdots & \theta_{N+1-K,N+\Delta N-K} \\ \vdots & \vdots & \ddots & \vdots & \vdots & \ddots & \vdots \\ \theta_{N+\Delta N-K,1} & \theta_{N+\Delta N-K,2} & \cdots & \theta_{N+\Delta N-K,N-K} & \theta_{N+\Delta N-K,N+1-K} & \cdots & \theta_{N+\Delta N-K,N+\Delta N-K} \end{bmatrix}$$

FIG. 17

FIG. 18

Data 1 encoded based on an RS ($N_1$, $K_1$, $T_1$, m) code pattern

Data 2 encoded based on an RS ($N_2$, $K_2$, $T_2$, m) code pattern

Data 3 encoded based on an RS ($N_s$, $K_s$, $T_s$, m) code pattern

First polynomial evaluation module
$[\,M(\alpha^{2T_1-1}),\,...,\,M(\alpha^0)\,]$

Second polynomial evaluation module
$[M(\alpha^{2T_2-1}),\,...,M(\alpha^{2T_1})]$

$s^{th}$ polynomial evaluation module
$[M(\alpha^{2T_s-1}),\,...,M(\alpha^{2T_{s-1}})]$

First constant coefficient multiply-add module corresponding to coefficients
$[\theta_{(j_1,N_1-K_1)},\,...,\,\theta_{(j_1,1)}]$
$j_1=1,\,2,\,...,\,(N_1-K_1)$

Second constant coefficient multiply-add module corresponding to coefficients
$[\theta_{(j_2,N_2-K_2)},\,...,\,\theta_{(j_2,1)}]$
$j_2=1,\,2,\,...,\,(N_2-K_2)$

$s^{th}$ constant coefficient multiply-add module corresponding to coefficients
$[\theta_{(j_s,N_s-K_s)},\,...,\,\theta_{(j_s,1)}]$
$j_s=1,\,2,\,...,\,(N_s-K_s)$

$P_{(N_1-K_1-1)},\,...,\,p_0$

$P_{(N_2-K_2-1)},\,...,\,p_0$

$P_{(N_s-K_s-1)},\,...,\,p_0$

Combination module 1910

Codeword

FIG. 19

EP 4 765 695 A1

47

Start

S101: A feedforward module receives to-be-encoded data with a parallelism of n symbols per cycle

S102: The feedforward module performs calculation in a finite field based on a symbol of the to-be-encoded data received in a current cycle, to obtain a single-cycle polynomial corresponding to the current cycle

S103: A feedback module receives the single-cycle polynomial, corresponding to the current cycle, output by the feedforward module, and performs calculation in the finite field based on the single-cycle polynomial corresponding to the current cycle and a first polynomial indicating a symbol received in a historical cycle, to obtain a second polynomial

Determine whether the current cycle is a $(K/n)^{th}$ cycle for receiving the to-be-encoded data

No

Yes

Determine, as a target polynomial indicating the to-be-encoded data, the second polynomial obtained by the feedback module through calculation

S104: Perform calculation based on a constant coefficient matrix and the target polynomial, to obtain a check sequence of the to-be-encoded data

S105: Combine the to-be-encoded data and the check sequence of the to-be-encoded data, to obtain a codeword obtained by encoding the to-be-encoded data based on a forward error correction encoding scheme

End

FIG. 20

FIG. 21

Encoding apparatus 2200

Receiving unit 2210

Calculation unit 2220

Determining unit 2230

Combination unit 2240

Control unit 2250

FIG. 22

## INTERNATIONAL SEARCH REPORT

| International application No. |
|---|
| **PCT/CN2024/097060** |

### A. CLASSIFICATION OF SUBJECT MATTER

H04L 1/00(2006.01)i

According to International Patent Classification (IPC) or to both national classification and IPC

### B. FIELDS SEARCHED

Minimum documentation searched (classification system followed by classification symbols)

IPC:H04L

Documentation searched other than minimum documentation to the extent that such documents are included in the fields searched

Electronic data base consulted during the international search (name of data base and, where practicable, search terms used)

CNABS, CNTXT, VEN, WOTXT, EPTXT, USTXT, CNKI, 3GPP: 前馈, 反馈, 多项式, 历史, 以前, 之前, 拍, 周期, 编码, 前向纠错, Feed forward, Feedback, Polynomial, Historical, Previous, before, Beat Period, Encoding, Forward Error Correction, FEC

### C. DOCUMENTS CONSIDERED TO BE RELEVANT

| Category* | Citation of document, with indication, where appropriate, of the relevant passages | Relevant to claim No. |
|---|---|---|
| A | CN 113497628 A (INTEL CORP.) 12 October 2021 (2021-10-12) description, paragraphs [0022]-[0024] and [0040]-[0100] | 1-15 |
| A | CN 106603085 A (BUILDWIN SEMICONDUCTOR (SHENZHEN) LIMITED et al.) 26 April 2017 (2017-04-26) entire document | 1-15 |
| A | CN 110971244 A (TIANJIN UNIVERSITY) 07 April 2020 (2020-04-07) entire document | 1-15 |
| A | EP 2309649 A1 (ROHDE & SCHWARZ GMBH & CO., KG) 13 April 2011 (2011-04-13) entire document | 1-15 |

☐ Further documents are listed in the continuation of Box C.   ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **13 August 2024** | **15 August 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2024/097060**

| Patent document cited in search report | | | Publication date (day/month/year) | Patent family member(s) | | | Publication date (day/month/year) |
|---|---|---|---|---|---|---|---|
| CN | 113497628 | A | 12 October 2021 | US | 2020304150 | A1 | 24 September 2020 |
| | | | | US | 11770138 | B2 | 26 September 2023 |
| | | | | US | 2023370095 | A1 | 16 November 2023 |
| | | | | EP | 3893401 | A1 | 13 October 2021 |
| CN | 106603085 | A | 26 April 2017 | CN | 106603085 | B | 14 April 2020 |
| CN | 110971244 | A | 07 April 2020 | | None | | |
| EP | 2309649 | A1 | 13 April 2011 | EP | 2309650 | A1 | 13 April 2011 |

Form PCT/ISA/210 (patent family annex) (July 2022)

**EP 4 765 695 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311177437